(19) Europäisches Patentamt
European Patent Office
Office européen des brevets

(11) EP 1 296 339 A2

(12) **EUROPEAN PATENT APPLICATION**

(43) Date of publication:
**26.03.2003 Bulletin 2003/13**

(51) Int Cl.[7]: **H01G 9/20**

(21) Application number: **02021061.3**

(22) Date of filing: **20.09.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **20.09.2001 JP 2001287482**

(71) Applicant: **FUJI PHOTO FILM CO., LTD.**
**Kanagawa-ken (JP)**

(72) Inventor: **Tsukahara, Jiro**
**Minami-Ashigara-shi, Kanagawa-ken (JP)**

(74) Representative: **Solf, Alexander, Dr.**
**Patentanwälte**
**Dr. Solf & Zapf**
**Candidplatz 15**
**81543 München (DE)**

(54) **Method for producing a photoelectrochemical cell**

(57) A method for producing a photoelectric conversion device comprising a conductive support and a photosensitive layer containing fine semiconductor particles onto which a dye is adsorbed, comprising the step of electrolytically reducing the fine semiconductor particles.

EP 1 296 339 A2

**Description**

FIELD OF THE INVENTION

The present invention relates to a method for producing a photoelectric conversion device comprising a semiconductor fine particle sensitized by a dye, a photoelectric conversion device produced by the method and a photoelectric cell comprising the photoelectric conversion device.

BACKGROUND OF THE INVENTION

Photoelectric conversion devices are used for various kinds of optical sensors, copiers, photoelectric generators, etc. Put into practical use are various types of photoelectric conversion devices, such as those using metals, those using semiconductors, those using organic pigments or dyes, combinations thereof.

U.S. Patents 4,927,721, 4,684,537, 5,084,365, 5,350,644, 5,463,057 and 5,525,440, WO 98/50393, JP 7-249790 A and JP 10-504521 A disclose photoelectric conversion devices utilizing fine semiconductor particles sensitized by dyes, and materials and producing methods for making such photoelectric conversion devices. A photoelectric conversion device comprising fine semiconductor particles sensitized by a dye is referred to as a dye-sensitized photoelectric conversion device hereinafter. The dye-sensitized photoelectric conversion device is advantageous because it can be produced at relatively low costs with using an inexpensive metal such as titanium dioxide without high purification. However, the conventional, dye-sensitized photoelectric conversion devices do not necessarily have sufficiently high photoelectric conversion efficiency. It is thus highly desired to develop a dye-sensitized photoelectric conversion device exhibiting improved photoelectric conversion efficiency.

OBJECT OF THE INVENTION

An object of the present invention is to provide a method for producing a dye-sensitized photoelectric conversion device excellent in photoelectric conversion efficiency.

Another object of the present invention is to provide a photoelectric conversion device produced by the method.

A further object of the present invention is to provide a photoelectric cell comprising the photoelectric conversion device.

SUMMARY OF THE INVENTION

As a result of intense research in view of the above objects, the inventor has found that a dye-sensitized photoelectric conversion device using fine semiconductor particles carried out electrolytic reduction is excellent in photoelectric conversion efficiency. The present invention has been accomplished by this finding.

Thus, the method of the present invention is a method for producing a photoelectric conversion device comprising a conductive support and a photosensitive layer containing fine semiconductor particles on which a dye is adsorbed, wherein the method comprises the step of electrolytically reducing the fine semiconductor particles.

The photoelectric conversion device of the present invention is produced by the above method of the present invention. The photoelectric cell of the present invention comprises the photoelectric conversion device.

With the following conditions satisfied, further improvement is achieved in photoelectric conversion efficiency of the photoelectric conversion device and the photoelectric cell of the present invention.

(1) In the electrolytic reduction of a fine semiconductor particles, electrolyte solution composed of an electrolyte salt and a solvent is preferably used.
(2) The electrolyte salt preferably comprises an alkali metal ion or an alkaline earth metal ion.
(3) The electrolyte salt preferably comprises an anion selected from the group consisting of a nitrate ion, $ClO_4^-$, $BF_4^-$, $PF_6^-$, $SbF_6^-$, $AsF_6^-$, a trifluoromethane sulfonate ion, a bis(trifluoroethanesulfonyl)imide ion and a tris(trifluoromethanesulfonyl)methide ion.
(4) The solvent is preferably water.
(5) The electrolytic reduction of the fine semiconductor particles is preferably carried out before the dye is adsorbed on the fine semiconductor particles.
(6) In the step of the electrolytic reduction, 10 nA to 10 mA of current is preferably provided per 1 $cm^2$ of said conductive support.
(7) The fine semiconductor particles is preferably oxide, more preferably titanium oxide.
(8) The dye is preferably a ruthenium complex dye.

BRIEF DESCRIPTION OF THE DRAWINGS

Fig. 1 is a partial cross sectional view showing a preferable structure of a photoelectric conversion device of the present invention;

Fig. 2 is a partial cross sectional view showing another preferable structure of a photoelectric conversion device of the present invention;

Fig. 3 is a partial cross sectional view showing a further preferable structure of a photoelectric conversion device of the present invention;

Fig. 4 is a partial cross sectional view showing a still further preferable structure of a photoelectric conversion device of the present invention;

Fig. 5 is a partial cross sectional view showing a still further preferable structure of a photoelectric conversion device of the present invention;

Fig. 6 is a partial cross sectional view showing a still further preferable structure of a photoelectric conversion device of the present invention;

Fig. 7 is a partial cross sectional view showing a still further preferable structure of a photoelectric conversion device of the present invention;

Fig. 8 is a partial cross sectional view showing a still further preferable structure of a photoelectric conversion device of the present invention;

Fig. 9 is a partial cross sectional view showing a still further preferable structure of a photoelectric conversion device of the present invention; and

Fig. 10 is a partial cross sectional view showing the structure of the photoelectric conversion device produced in Examples.

DETAILED DESCRIPTION OF THE PREFERRED EMBODIMENTS

The method of the present invention for producing a photoelectric conversion device is a method for producing a photoelectric conversion device comprising a conductive support and a photosensitive layer. The photosensitive layer contains a semiconductor fine particle on which a dye is adsorbed. In the method of the present invention, the electrolytic reduction of the fine semiconductor particles is carried out to improve conversion efficiency of the photoelectric conversion device. The photoelectric conversion device of the present invention is produced by the method of the present invention. The photoelectric cell of the present invention comprises the photoelectric conversion device of the present invention. The electrolytic reduction in the method of the present invention and the photoelectric conversion device and the photoelectric cell of the present invention will be described in detail below.

[1] Electrolytic reduction

The method of the present invention for producing a photoelectric conversion device comprises the step of electrolytic reduction of a fine semiconductor particles. The method may also comprise the step of coating fine semiconductor particles on a conductive support, the step of heat-treating the fine semiconductor particles coated on the conductive support, and a step making dyes adsorb on the fine semiconductor particles. Generally, the electrolytic reduction may be carried out after the heat treatment of the fine semiconductor particles or after dye adsorption. Though the electrolytic reduction may be carried out before or after dye adsorption, it is preferable to conduct the electrolytic reduction before dye adsorption. When the electrolytic reduction is carried out before dye adsorption, it is preferable that a heat treatment is carried out again to activate the surfaces of fine semiconductor particles after the electrolytic reduction.

The electrolytic reduction can be carried out by filling an electrolyte, or an electrolyte solution or composition comprising the electrolyte, etc. between the conductive support coated with the fine semiconductor particles (working electrode) and a counter electrode, connecting the working electrode and the counter electrode to the negative pole and positive pole of a power supply, respectively, and supplying current to these electrodes. The intensity of current supplied is preferably 10 nA to 10 mA, more preferably 100 nA to 1 mA, particularly 1 to 100 μA, per 1 $cm^2$ of the working electrode. Voltage applied in the electrolytic reduction is not particularly restrictive, and it may be properly adjusted depending on the predetermined current value. The voltage applied is generally 0.1 to 10 V, preferably 0.3 to 3 V. The current-supplying time is generally 1 minute to 24 hours, preferably 10 minutes to 3 hours.

The electrolytic reduction may be carried out by a three-pole method using a potentiostat. In this case, the working electrode is polarized on the cathode side. When a reference electrode is a saturated calomel electrode, voltage set at the working electrode is preferably -10 V to 0 V, more preferably -3 V to 0 V.

In the step of the electrolyte reduction, an electrolyte solution composed of an electrolyte salt and a solvent is preferably used. The electrolyte solution may further comprise additives such as organic or inorganic acids or bases.

Though the electrolyte salt is not particularly limited, it preferably comprises a cation such as an alkali metal ion ($Li^+$, $Na^+$, $K^+$, $Rb^+$, $Cs^+$, etc.), an alkaline earth metal ion ($Mg^{2+}$, $Ca^{2+}$, $Sr^{2+}$, $Ba^{2+}$, etc.), $Al^{3+}$, $Zn^{2+}$, $NH_4^+$, an alkylammonium ion (a methylammonium ion, a tetramethylammonium ion, a tetrabutylammonium ion, a hexadecyltrimethylammonium ion, an N,N-dimethylpyrrolidinium ion, etc.) and an imidazolium ion (an imidazolium ion, a 1-methylimidazolium ion, 1,3-dimethylimidazolium ion, 1-ethyl-3-methylimidazolium ion, etc.). Preferable among them are an alkali metal ion and an alkaline earth metal ion, particularly an alkali metal ion. Most preferable among the alkali metal ions is $Li^+$.

The electrolyte salt preferably comprises a conjugated anion of a strong acid. Examples of the conjugated anions of strong acids include halide ions such as $F^-$, $Cl^-$, $Br^-$, $I^-$; sulfate ion; nitrate ion; phosphate ion; $ClO_4^-$; $BF_4^-$; $PF_6^-$; $SbF_6^-$; $AsF_6^-$; trifluoroacetate ion; methane sulfonate ion, *p*-toluensulfonate ion, trifluoromethane sulfonate ion, bis(trifluoroethanesulfonyl)imide ion, tris(trifluoromethanesulfonyl)methide ion, etc. Preferable among them are nitrate ion, $ClO_4^-$, $BF_4^-$, $PF_6^-$, $SbF_6^-$, $AsF_6^-$, trifluoromethane sulfonate ion, bis(trifluoroethanesulfonyl)imide ion and tris(trifluoromethanesulfonyl)methide ion.

The electrolyte salts may be used alone or in combination. The concentration of each electrolyte salt in the electrolyte solution is preferably 0.001 to 5 mol/L, more preferably 0.01 to 1 mol/L.

A solvent used for the electrolyte solution is not particularly limited as long as it dissolves electrolyte salts. A solvent used for the electrolyte solution is generally water or an organic solvent, preferably water. Examples of the organic solvents include alcohols such as methanol, ethanol, t-butanol and benzyl alcohol; nitriles such as acetonitrile, propionitrile and 3-methoxypropionitrile; nitromethane; halogenated hydrocarbons such as dichloromethane, dichloroethane, chloroform and chlorobenzene; ethers such as dimethoxyethane, tetrahydrofuran; dimethylsulfoxide; amides such as *N*,*N*-dimethylformamide and *N*,*N*-dimethylacetamide; *N*-methylpyrrolidone; 1,3-dimethylimidazolidinone; 3-methyloxazolidinone; esters such as ethyl acetate and butyl acetate; carbonates such as diethyl carbonate, ethylene carbonate and propylene carbonate; ketones such as acetone, 2-butanone and cyclohexanone; etc.

When an electrolyte salt containing $Li^+$ is used, a counter electrode made of a lithium metal in the electrolytic reduction can easily proceed an electrolytic reaction with the working electrode and the counter electrode contacted to each other, without using an external power supply. In this case, the working electrode and the counter electrode may be short-circuited, or they may be contacted to each other via a proper resistor. Resistance between the working electrode and the counter electrode is preferably 0 Ω (short-circuited) to 50 Ω. In this case, an aprotic, organic solvent is preferably used for the electrolyte solution, and the electrolyte reduction is preferably carried out in a dried air flow.

The working electrode is preferably washed after the electrolyte reduction. The solvent used for washing is preferably the same as that used for the above electrolyte solution.

[2] Photoelectric conversion device

The photoelectric conversion device of the present invention is produced by the above method of the present invention. As shown in Fig. 1, the photoelectric conversion device preferably has a laminate structure comprising an electrically conductive layer 10, a photosensitive layer 20 containing fine semiconductor particles 21 sensitized by dye 22 and an charge-transporting material 23 penetrating into voids among the fine semiconductor particles 21, a charge transfer layer 30, and a counter electrode layer 40 in this order. The charge-transporting material 23 in the photosensitive layer 20 may be generally the same as the charge transfer material used in the charge transfer layer 30. An undercoating layer 60 may be disposed between the electrically conductive layer 10 and the photosensitive layer 20. The electrically conductive layer 10 and/or the counter electrode layer 40 may be supported by a substrate 50 to improve the strength of the photoelectric conversion device. A layer composed of the electrically conductive layer 10 and the substrate 50 optionally used for supporting it is referred to as "conductive support," and a layer composed of the counter electrode layer 40 and the substrate 50 optionally used for supporting it is referred to as "counter electrode" hereinafter. The electrically conductive layer 10, the counter electrode layer 40 and the substrate 50 shown in Fig. 1 may be transparent.

A photoelectric cell is constituted by connecting the photoelectric conversion device to an external circuit to electrically work or generate electricity in the external circuit. A photo sensor is such a photoelectric conversion device for sensing optical information. Such a photoelectric cell that has a charge transfer material mainly composed of an ion-conductive material is referred to as a photo-electrochemical cell. A photoelectric cell intended for power generation with solar light is referred to as a solar cell.

In the photoelectric conversion device of the present invention shown in Fig. 1, a light introduced into the photosensitive layer 20 excites the dye 22, etc., to generate excited high-energy electrons, which are transported to a conduction band of the fine semiconductor particles 21, and are diffused to reach the electrically conductive layer 10. At this time, the dye 22 is in an oxidized form. In a photoelectric cell, electrons in the electrically conductive layer

10 return to the oxidized dye through the counter electrode layer 40 and the charge transfer layer 30 while doing job in an outside circuit, so that the dye 22 is regenerated. The photosensitive layer 20 acts as a negative electrode. The counter electrode layer 40 acts as a positive electrode. In a boundary of adjacent layers such as the electrically conductive layer 10 and the photosensitive layer 20; the photosensitive layer 20 and the charge transfer layer 30; the charge transfer layer 30 and the counter electrode layer 40; etc., components of each layer may be diffused and mixed. Each of the layers will be explained in detail below.

(A) Conductive support

The conductive support is: (1) a single layer of an electrically conductive layer, or (2) two layers of an electrically conductive layer and a substrate. In the case (1), the electrically conductive layer is preferably made of a material having such a strength that it can fully seal the photoelectric conversion device, for example, a metal such as platinum, gold, silver, copper, zinc, titanium, aluminum and an alloy thereof. In the case (2), a substrate having an electrically conductive layer containing an electrically conductive material formed on the photosensitive layer side may be used. Preferable examples of the electrically conductive materials include metals such as platinum, gold, silver, copper, aluminum, rhodium and indium; carbon; electrically conductive metal oxides such as indium-tin composite oxides and tin oxides doped with fluorine; etc. The electrically conductive layer preferably has a thickness of 0.02 to 10 μm.

The surface resistance of the conductive support is desirably as low as possible. The surface resistance of the conductive support is preferably 100 Ω/square or less, more preferably 40 Ω/square or less. The lower limit of the surface resistance is generally about 0.1 Ω/square, though it is not particularly limited.

When light is irradiated from the conductive support side, it is preferred that the conductive support is substantially transparent. The term "substantially transparent" used herein means that 10% or more of light transmittance is obtained. The light transmittance of the conductive support is preferably 50% or more, particularly 70% or more.

The transparent conductive support is preferably provided by forming the electrically conductive, transparent layer comprising an electrically conductive metal oxide on the transparent substrate of such material as a glass and a plastic by coating or vapor deposition. The electrically conductive, transparent layer is preferably made of tin dioxide doped with fluorine. The transparent substrate may be made of a glass such as a low-cost soda glass excellent in strength. In addition, a transparent polymer film may be used as the transparent substrate to obtain a low-cost, flexible photoelectric conversion device. Materials usable for the transparent polymer film are triacetylcellulose (TAC), polyethylene terephthalate (PET), polyethylene naphthalate (PEN), syndiotactic polystyrene (SPS), polyphenylenesulfide (PPS), polycarbonate (PC), polyarylate (PAr), polysulfone (PSF), polyestersulfone (PES), polyetherimide (PEI), cyclic polyolefins, brominated phenoxy resins, etc. To secure sufficient transparency, the amount of the electrically conductive metal oxide coated is preferably 0.01 to 100 g per 1 $m^2$ of the glass or plastic substrate.

It is preferable to use a metal lead to reduce the resistance of the transparent conductive support. The metal lead is preferably made of a metal such as platinum, gold, nickel, titanium, aluminum, copper, silver, etc., particularly made of aluminum or copper. The metal lead is preferably formed on the transparent substrate by a vapor deposition method, a sputtering method, etc., preferably with a electrically conductive, transparent layer comprising conductive tin oxide or ITO formed thereon. It is also preferable that after the electrically conductive, transparent layer is formed on the transparent substrate, the metal lead is formed on the electrically conductive, transparent layer. Decrease in incident light quantity by the metal lead is suppressed to preferably 10% or less, more preferably 1 to 5%.

(B) Photosensitive layer

In the photosensitive layer, the fine semiconductor particles act as a photosensitive substance to absorb light and conduct charge separation, thereby generating electrons and positive holes. In the dye-sensitized, fine semiconductor particles, the light absorption and the generation of electrons and positive holes are primarily caused by the dye, and the fine semiconductor particles receive and convey electrons or positive holes. The semiconductor used in the present invention is preferably an *n*-type semiconductor, in which conductor electrons act as a carrier under a photo-excitation condition to generate anode current.

(1) Semiconductor

Used as the semiconductor may be simple semiconductors such as silicon and germanium; III-V series compound semiconductors; metal chalcogenides such as metal oxides, metal sulfides and metal selenides; compounds having a perovskite structure such as strontium titanate, calcium titanate, sodium titanate, barium titanate and potassium niobate; etc.

Examples of the metal chalcogenides include oxides of titanium, tin, zinc, iron, tungsten, zirconium, hafnium, strontium, indium, cerium, yttrium, lanthanum, vanadium, niobium or tantalum; sulfides of cadmium, zinc, lead, silver,

antimony or bismuth; selenides of cadmium or lead; cadmium telluride; etc. Additionally, compound semiconductors such as phosphides of zinc, gallium, indium or cadmium, selenides of gallium-arsenic or copper-indium, copper-indium sulfide, etc. may be used in the present invention.

Examples of the semiconductors used in the present invention are preferably Si, $TiO_2$, $SnO_2$, $Fe_2O_3$, $WO_3$, ZnO, $Nb_2O_5$, CdS, ZnS, PbS, $Bi_2S_3$, CdSe, CdTe, GaP, InP, GaAs, $CuInS_2$ and $CuInSe_2$, more preferably $TiO_2$, ZnO, $SnO_2$, $Fe_2O_3$, $WO_3$, $Nb_2O_5$, CdS, PbS, CdSe, InP, GaAs, $CuInS_2$ and $CuInSe_2$, most preferably $TiO_2$ and $Nb_2O_5$, particularly $TiO_2$.

The semiconductor used in the present invention may have a monocrystalline or polycrystalline structure. From the viewpoints of production cost, stable supply of raw materials, energy-payback time, etc., the semiconductor is preferably polycrystalline, particularly a porous layer of fine semiconductor particles.

The particle size of the fine semiconductor particles is generally on the level of nm to μm. The average size of primary semiconductor particles, which is determined by averaging the diameters of circles equivalent to projected areas thereof, is preferably 5 to 200 nm, more preferably 8 to 100 nm. Further, the average size of secondary semiconductor particles in dispersion is preferably 0.01 to 100 μm.

Two or more of the fine semiconductor particles having different particle size distributions may be used in combination for the photosensitive layer. In this case, the average particle size of the smaller particles is preferably 5 nm or less. To improve a light-capturing rate of the photoelectric conversion device by scattering ray of incident light, the fine semiconductor particles having a large particle size, e.g. approximately 300 nm in diameter, may be used for the photosensitive layer.

Preferably usable to produce the fine semiconductor particles are sol-gel methods described in Sumio Sakka, "Science of Sol-Gel Method," issued by Agune Shofusha (1998), and "Thin Film-Coating Technology by Sol-Gel Method" (1995) issued by the Technical Information Association, etc.; and gel-sol methods described in Tadao Sugimoto, "Synthesis of Mono-Dispersion Particles and Control of Their Size and Form by Novel Gel-Sol Method," and MATERIA, Vol. 35, No. 9, pages 1012 to 1018 (1996). Also preferable is a method developed by Degussa, which comprises preparing oxides by subjecting chlorides to a high-temperature hydrolysis in an oxyhydrogen salt.

In the case of using the fine semiconductor particles of titanium oxide, the above-described sol-gel method, gel-sol method and high-temperature hydrolysis method are preferably used, and a sulfuric acid method and a chlorine method described in Manabu Seino, "Titanium oxide - Properties and Applied Technique," issued by Gihodo Shuppan, (1997) may also be used. Further preferable as the sol-gel method are those described in Christophe J. Barb'e, et al, the Journal of American Ceramic Society, Vol. 80, No. 12, pages 3157 to 3171 (1997) and Burnside, et al, Chemistry of Materials, Vol. 10, No. 9, pages 2419 to 2425.

(2) Layer of fine semiconductor particles

The fine semiconductor particles may be applied to the conductive support by a method for coating a conductive support with a dispersion or colloidal solution containing fine semiconductor particles, in addition to the above-mentioned sol-gel method. A wet-type film production method is relatively advantageous for the mass production of the photoelectric conversion device, improvement of properties of the solution containing fine semiconductor particles, improvement of the adaptability of the conductive support, etc. Typical examples of such wet-type film production methods are a coating method and a printing method.

The dispersion containing fine semiconductor particles may be prepared by crushing the semiconductor in a mortar; by dispersing the semiconductor while grinding it in a mill, or by synthesizing and precipitating the fine semiconductor particles in a reaction solvent, etc. in addition to the above-mentioned sol-gel method.

Usable as dispersion solvents for the fine semiconductor particles may be water or organic solvents such as methanol, ethanol, isopropyl alcohol, dichloromethane, acetone, acetonitrile, ethyl acetate, etc. Polymers such as polyethylene glycol, surfactants, acids, chelating agents, etc. may be used as dispersing agents, if necessary. Polyethylene glycol is preferably added to the dispersion, because changing the molecular weight of the polyethylene glycol makes it possible to control the viscosity of the dispersion, and form a layer of fine semiconductor particles resistant to peeling.

Preferable coating methods include application methods such as a roller method and a dipping method, metering methods such as an air-knife method and a blade method, etc. Further, preferable as methods for applying and metering in the same portion are a wire-bar method disclosed in JP 58-4589 B, a slide-hopper method described in U. S. Patents 2,681,294, 2,761,419 and 2,761,791, an extrusion method, a curtain method, etc. Further preferable as commonly usable methods are a spin method and a spray method. Usable as wet printing methods are three major printing methods by relief printing, offset printing and gravure printing, as well as an intaglio printing method, a gum printing method, a screen printing method, etc. A film production method may be selected from these methods depending on the viscosity of the dispersion and the desired wet thickness.

The viscosity of the dispersion comprising the fine semiconductor particles materially depends on the kind and dispersion property of the fine semiconductor particles, the kind of a solvent, and additives such as a surfactant

and a binder. Preferable methods used for high-viscosity dispersions, (for example, 0.01 to 500 poise) are an extrusion method, a casting method, a screen-printing method, etc. For low-viscosity dispersions (e.g. 0.1 poise or less), preferable examples of methods for forming uniform films are a slide-hopper method, a wire-bar method and a spin method. An extrusion method may be used for the low-viscosity dispersion if it is coated to some extent. A film production method may be selected like this depending on the viscosity of the dispersion, the amount of coated dispersion, the material of the support, the coating speed, etc.

The layer of fine semiconductor particles is not limited to a single layer. Dispersions comprising the fine semiconductor particles having different particle sizes may be coated to form a multi-layer coating. Alternatively, dispersions containing different fine semiconductor particles, binders or additives may be coated to form a multi-layer coating. The multi-layer coating is effective, when it is impossible to form a layer having a sufficient thickness by one coating step. Suitable for the multi-layer coating are an extrusion method and a slide-hopper method. At the time of forming the multi-layer coating, a plurality of layers may be coated simultaneously or one on the other from several times to ten-several times. In the latter case, a screen method is also preferably used.

Generally, the thicker the layer of fine semiconductor particles (having a thickness equal to that of the photosensitive layer), the higher the light-capturing rate, because a larger amount of the dye is incorporated therein per a unit-projected area. In this case, however, there is large loss owing to recombination of electric charges because of increased diffusion distance of the generated electrons. Thus, the preferable thickness of the layer of fine semiconductor particles is 0.1 to 100 μm. When the photoelectric conversion device of the present invention is used in a solar cell, the thickness of the layer of fine semiconductor particles is preferably 1 to 30 μm, more preferably 2 to 25 μm. The amount of the fine semiconductor particles applied to the conductive support is preferably 0.5 to 400 g, more preferably 5 to 100 g, per 1 $m^2$ of the substrate.

After applying the fine semiconductor particles to the conductive support, the particles are preferably subjected to a heat treatment, thereby bringing them into electronic contact with each other, and thus increasing the strength of the resultant coating and the adherence to the support. The heating temperature is preferably 40 to 700°C, more preferably 100 to 600°C. High-temperature treatment is not preferable to a substrate having a low melting or softening point, such as a polymer film substrate, because it tends to deteriorate such a substrate. The heat treatment is preferably carried out at as low a temperature as possible from the viewpoint of cost. Such a low-temperature heat treatment can be made possible by the presence of fine semiconductor particles having a size of 5 nm or smaller, a mineral acid, etc.

After the heat treatment, the layer of fine semiconductor particles may be subjected to a chemical metal-plating using an aqueous titanium tetrachloride solution, etc. or electrochemical metal-plating using an aqueous titanium trichloride solution, etc., to increase the surface area and purity of the fine semiconductor particles, thereby improving the efficiency of injecting electrons into the particles from the dye.

The layer of fine semiconductor particles preferably has a large surface area to adsorb a large amount of a dye. The layer of fine semiconductor particles coated onto the substrate has a surface area of preferably 10 times or more, more preferably 100 times or more, its projected area. The upper limit of the surface area is generally about 1000 times, though it is not particularly limited.

As mentioned above, in the producing method of the present invention, the electrolytic reduction of the fine semiconductor particles is carried out. Though the electrolytic reduction may be carried out before or after dye adsorption, it is preferably carried out before dye adsorption. When the electrolytic reduction is carried out before dye adsorption, it is preferable that a heat treatment is carried out again to activate the surfaces of fine semiconductor particles after the electrolytic reduction.

(3) Dye

Any compounds capable of absorbing visible and near infrared rays to sensitize the semiconductor may be used as the dye for the photosensitive layer. Preferable examples of such dyes include metal complex dyes, methine dyes, porphyrin-type dyes and phthalocyanine dyes. Two or more kinds of dyes may be used in combination to obtain a large photoelectric conversion wavelength region and high photoelectric conversion efficiency. In the case of using a plurality of dyes, the kinds and mixing ratios of the dyes may be determined depending on the wavelength region and strength distribution of the light source.

The dye preferably has an appropriate interlocking group for interacting with the surface of the fine semiconductor particles. Preferable interlocking groups include acidic groups such as -COOH, -OH, $-SO_2H$, $-P(O)(OH)_2$ and $-OP(O)(OH)_2$ and π-conductive chelating groups such as oxime, dioxime, hydroxyquinoline, salicylate and α-ketoenolate groups. Particularly preferable among them are -COOH, $-P(O)(OH)_2$ and $-OP(O)(OH)_2$. The interlocking group may form a salt with an alkali metal, etc. or an intramolecular salt. If the methine chain of the polymethine dye has an acidic group as in the case where the methine chain forms a squarylium or croconium ring, it may act as the interlocking group.

The preferred dyes used for the photosensitive layer are specifically described below.

(a) Metal complex dye

When the dye is a metal complex dye, the dye is preferably a metallophthalocyanine dye, a metalloporphyrin dye or a ruthenium complex dye, and it is particularly a ruthenium complex dye. The ruthenium complex dyes described in U.S. Patents 4,927,721, 4,684,537, 5,084,365, 5,350,644, 5,463,057 and 5,525,440, JP 7-249790 A, JP 10-504512 A and JP 2000-26487A, WO 98/50393, etc. may be used in the present invention.

The ruthenium complex dye is preferably represented by the following formula (I):

$$(A_1)_pRu(B\text{-}a)(B\text{-}b)(B\text{-}c) \qquad (I),$$

wherein $A_1$ represents a unidentate or bidentate ligand, preferably selected from the group consisting of Cl, SCN, $H_2O$, Br, I, CN, NCO, SeCN, a β-diketone derivative, an oxalate derivative and a dithiocarbamate derivative; *p* is an integer of 0 to 3; and B-a, B-b and B-c are independently organic ligands represented by the following formulae B-1 to B-10.

B-1 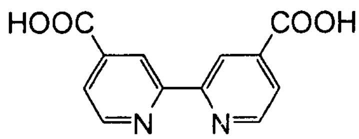

B-2 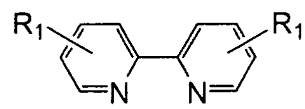

B-3 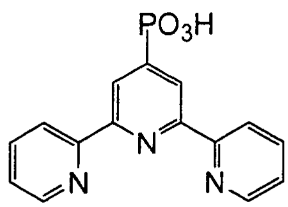

B-4 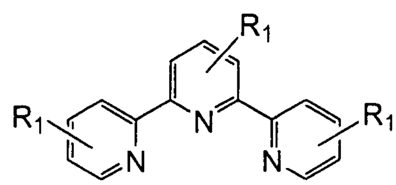

B-5 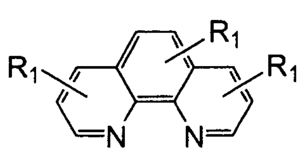

B-6 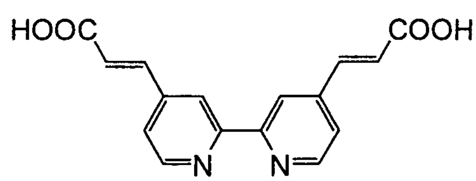

B-7 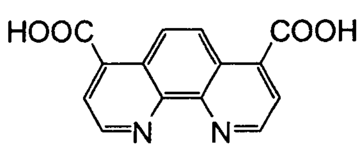

B-8 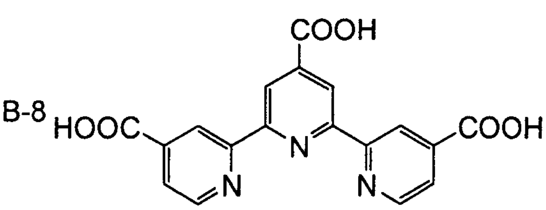

B-9 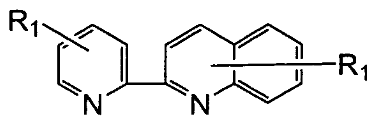 B-10 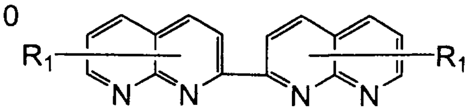

In the formulae B-1 to B-10, $R_1$ represents a hydrogen atom or a substituent. Specific examples of such substituents include halogen atoms, substituted or unsubstituted alkyl groups having 1 to 12 carbon atoms, substituted or unsubstituted aralkyl groups having 7 to 12 carbon atoms, substituted or unsubstituted aryl groups having 6 to 12 carbon atoms, the above-mentioned acidic groups that may form salts or chelating groups, etc. The alkyl group and the alkyl moiety of the aralkyl group may be straight or branched, and the aryl group and an aryl moiety of the aralkyl group may have a monocyclic or a polycyclic structure such as a condensed ring and a ring assembly. B-a, B-b and B-c may be the same or different. The ruthenium complex dye represented by the above general formula (I) may comprise only one or two of B-a, B-b and B-c.

Preferred examples of the metal complex dyes are illustrated below without intention of restriction.

$$(A_3)_pRu(B\text{-}a)(B\text{-}b)(B\text{-}c) \qquad (I),$$

| R | $A_1$ | p | B-a | B-b | B-c | $R_1$ |
|---|---|---|---|---|---|---|
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | CN | 2 | B-7 | B-7 | - | - |
| R-5 | SCN | 2 | B-7 | B-7 | - | - |
| R-6 | SCN | 2 | B-1 | B-2 | - | H |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 3 | B-8 | - | - | - |
| R-11 | CN | 3 | B-8 | - | - | - |
| R-12 | SCN | 1 | B-2 | B-8 | - | H |
| R-13 | - | 0 | B-1 | B-1 | B-1 | - |

R-14

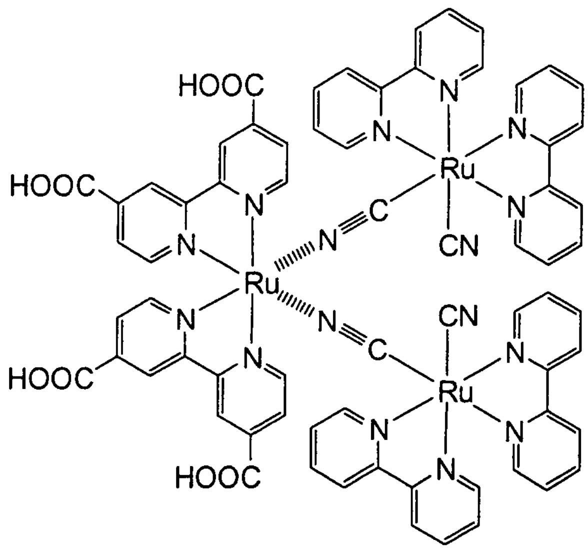

R-15

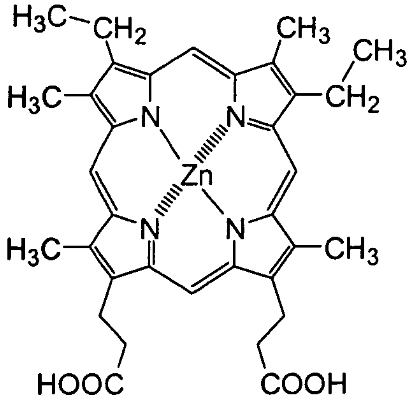

R-16

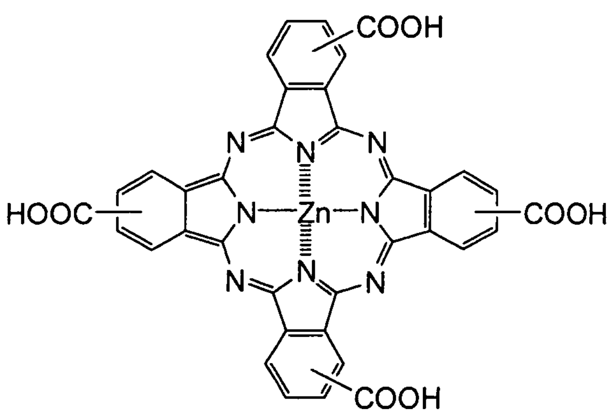

R-17

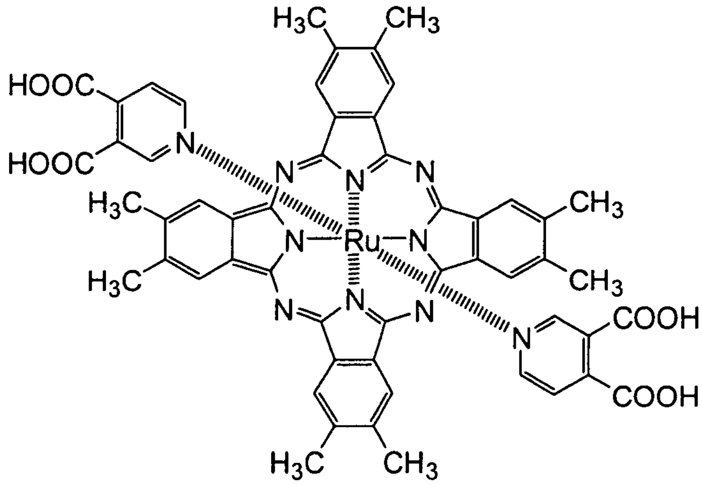

(b) Methine dye

The methine dyes used in the present invention are preferably cyanine dyes, merocyanine dyes or polymethine dyes such as a squarylium dyes. Examples of the polymethine dyes are described in JP 11-35836 A, JP 11-67285 A, JP 11-86916 A, JP 11-97725 A, JP 11-158395 A, JP 11-163378 A, JP 11-214730 A, JP 11-214731 A, JP 11-238905 A and JP 2000-26487 A, European Patents 892411, 911841 and 991092. The preferred methine dyes are specifically described below.

M-1

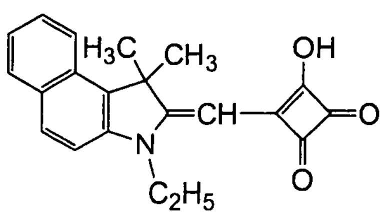

M-2

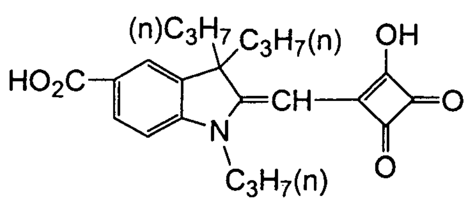

M-3

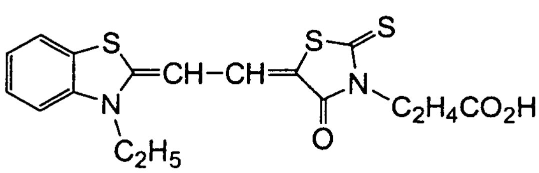

M-4

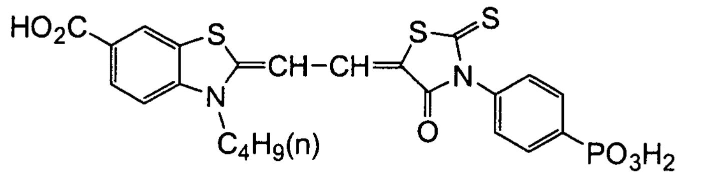

M-5

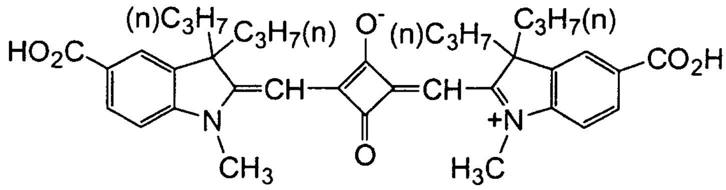

M-6

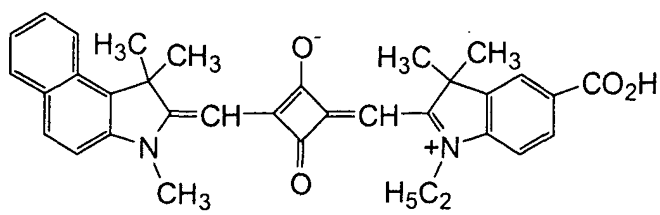

M-7

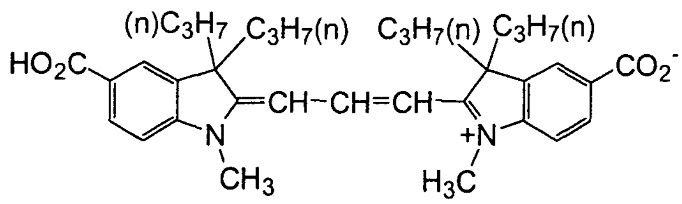

M-8

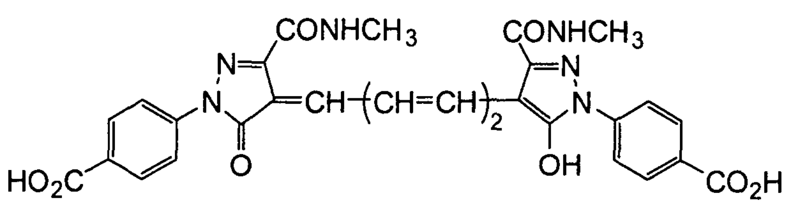

(4) Adsorption of dye onto fine semiconductor particles

The dye may be adsorbed onto the fine semiconductor particles by soaking the conductive support having the well-dried layer of fine semiconductor particles in a dye solution, or by coating the dye solution to the layer of fine semiconductor particles. In the former case, a soaking method, a dipping method, a roller method, an air-knife method,

etc. may be used. In the soaking method, the dye may be adsorbed at a room temperature or under reflux while heating as described in JP 7-249790 A. As the latter coating method, a wire-bar method, a slide-hopper method, an extrusion method, a curtain method, a spin-coating method, a spraying method, etc. may be used. Also, pigment may be applied in the form of image to the substrate by an inkjet method, etc., and this image per se may be used as a photoelectric conversion device.

Preferable examples of solvents for dissolving the dye include alcohols such as methanol, ethanol, *t*-butanol and benzyl alcohol; nitriles such as acetonitrile, propionitrile and 3-methoxypropionitrile; nitromethane; halogenated hydrocarbons such as dichloromethane, dichloroethane, chloroform and chlorobenzene; ethers such as diethylether and tetrahydrofuran; dimethylsulfoxide; amides such as *N*,*N*-dimethylformamide and *N*,*N*-dimethylacetamide; *N*-methylpyrrolidone; 1,3-dimethylimidazolidinone; 3-methyloxazolidinone; esters such as ethyl acetate and butyl acetate; carbonates such as diethyl carbonate, ethylene carbonate and propylene carbonate; ketones such as acetone, 2-butanone and cyclohexanone; hydrocarbons such as hexane, petroleum ether, benzene and toluene; and mixtures thereof.

The amount of the dye adsorbed is preferably 0.01 to 100 mmol per a unit surface area (1 $m^2$) of the layer of fine semiconductor particles. The amount of the dye adsorbed onto the fine semiconductor particles is preferably 0.01 to 1 mmol per 1 g of the fine semiconductor particles. With this adsorption amount of the dye, the semiconductor can be sufficiently sensitized. Too small an amount of the dye results in insufficient sensitization. On the other hand, if the amount of the dye is excessive, the dye not adsorbed onto the fine semiconductor particles is free, thereby reducing the sensitization of the fine semiconductor particles. To increase the adsorption amount of the dye, it is preferable that the layer of fine semiconductor particles is subjected to a heat treatment before the dye is adsorbed thereonto. After the heat treatment, it is preferable for the layer of fine semiconductor particles to quickly adsorb the dye while it is still at 60 to 150°C without returning to the room temperature, to prevent water from adsorbing onto the layer of fine semiconductor particles.

To weaken interaction such as association between the dyes, a colorless compound having surface activity may be co-adsorbed onto the fine semiconductor particles together with the dye. Examples of the colorless compound include steroid compounds (for example, chenodeoxycholic acid, taurodeoxycholic acid, etc.) having a group such as a carboxyl group and sulfonic acid group, and sulfonates shown below.

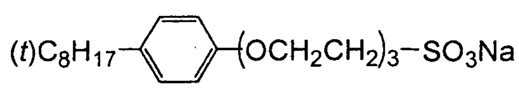

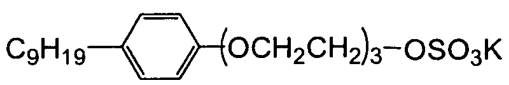

The dye not adsorbed on the layer of fine semiconductor particles is preferably removed by washing immediately after the dye adsorption process. The washing is preferably carried out in a wet-type washing bath with an organic solvent such as acetonitrile and an alcohol solvent.

The surfaces of the fine semiconductor particles may be treated with an amine compound or a quaternary salt thereof after the dye adsorption process. The amine compound is preferably pyridine, 4-*t*-butylpyridine, polyvinylpyridine, etc., and the quaternary salt is preferably tetrabutylammonium iodide, tetrahexylammonium iodide, etc. The amine compound or the quaternary salt may be used alone if it is liquid, or may be used in the form of a solution in an organic solvent.

(C) Charge transfer layer

The charge transfer layer comprises a charge transfer material having a function of supplying electrons to the oxidized dye. The charge transfer material used in the present invention may be (i) an ion-conductive, charge transfer material or (ii) a charge transfer material in a solid state through which carriers can be transported. Examples of the ion-conductive, charge transfer materials (i) include molten electrolytic salt compositions comprising molten electrolytic salts containing redox couples; electrolyte solutions having redox couples dissolved in solvents; so-called electrolytic gel compositions having solutions containing redox couples penetrating into polymer matrices; solid electrolytic compositions; etc. Examples of the carrier-transporting charge transfer materials (ii) include electron-transporting materials and hole-transporting materials. These materials may be used in combination. The charge transfer layer used in the present invention is preferably composed of the molten electrolytic salt composition or the electrolyte solution.

(1) Molten electrolytic salt composition

It is preferable to use a molten electrolytic salt as a charge transfer material to improve both photoelectric conversion efficiency and durability. The molten salt is in a liquid state at room temperature or has a low melting point. Examples of the molten electrolytic salts include a pyridinium salt, an imidazolium salt and a triazolium salt disclosed in WO95/18456, JP 8-259543 A, "Denki Kagaku (Electrochemistry)," 65, 11, 923 (1997). The melting point of the molten electrolytic salt is preferably 100°C or lower, particularly in a liquid state at around room temperature.

The molten salt electrolytes represented by the following general formulae (Y-a), (Y-b) and (Y-c) are preferably used in the present invention.

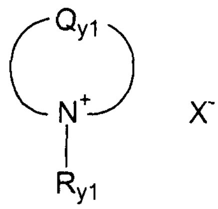 . . . (Y-a)

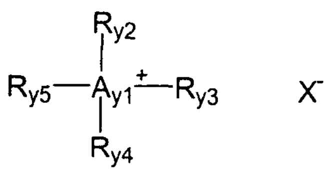 . . . (Y-b)

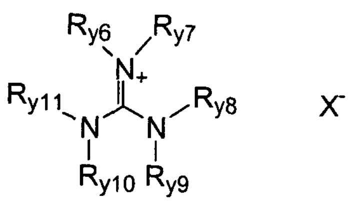 . . . (Y-c)

In the general formula (Y-a), $Q_{y1}$ represents an atom group forming an aromatic cation having a 5- or 6-membered ring structure with a nitrogen atom. $Q_{y1}$ is preferably composed of atoms selected from the group consisting of carbon, hydrogen, nitrogen, oxygen and sulfur. The 5-membered ring formed by $Q_{y1}$ is preferably an oxazole ring, a thiazole ring, an imidazole ring, a pyrazole ring, an iso-oxazole ring, a thiadiazole ring, an oxadiazole ring, a triazole ring, an indole ring or a pyrrole ring, more preferably an oxazole ring, a thiazole ring or an imidazole ring, particularly an oxazole ring or an imidazole ring. The 6-membered ring formed by $Q_{y1}$ is preferably a pyridine ring, a pyrimidine ring, a pyridazine ring, a pyrazine ring or a triazine ring, more preferably a pyridine ring.

In the general formula (Y-b), $A_{y1}$ represents a nitrogen atom or a phosphorus atom.

$R_{y1}$ to $R_{y11}$ in the general formulae (Y-a), (Y-b) and (Y-c) independently represent substituted or unsubstituted alkyl groups preferably having 1 to 24 carbon atoms, which may be straight, branched or cyclic, such as a methyl group, an ethyl group, a propyl group, an isopropyl group, a pentyl group, a hexyl group, an octyl group, a 2-ethylhexyl group, a *t*-octyl group, a decyl group, a dodecyl group, a tetradecyl group, a 2-hexyldecyl group, an octadecyl group, a cyclohexyl group, a cyclopentyl group, etc.; or substituted or unsubstituted alkenyl groups preferably having 2 to 24 carbon atoms, which may be straight or branched, such as a vinyl group, an allyl group, etc. Each of $R_{y1}$ to $R_{y11}$ is more preferably an alkyl group having 2 to 18 carbon atoms or an alkenyl group having 2 to 18 carbon atoms, particularly an alkyl group having 2 to 6 carbon atoms.

Two or more of $R_{y2}$ to $R_{y5}$ in the general formula (Y-b) may be bonded together to form a non-aromatic ring

containing $A_{y1}$. Two or more of $R_{y6}$ to $R_{y11}$ in the general formula (Y-c) may be bonded together to form a ring.

The general formulae (Y-a), (Y-b) and (Y-c) may have substituents. Preferable examples of the substituents include halogen atoms such as F, Cl, Br and I; a cyano group; alkoxy groups such as a methoxy group, an ethoxy group, a methoxyethoxy group and a methoxyethoxyethoxy group; aryloxy groups such as a phenoxy group; alkylthio groups such as a methylthio group and an ethylthio group; alkoxycarbonyl groups such as an ethoxycarbonyl group; carbonate groups such as an ethoxycarbonyloxy group; acyl groups such as an acetyl group, a propionyl group and a benzoyl group; sulfonyl groups such as a methanesulfonyl group and a benzenesulfonyl group; acyloxy groups such as an acetoxy group and a benzoyloxy group; sulfonyloxy groups such as a methanesulfonyloxy group and a toluenesulfonyloxy group; phosphonyl groups such as a diethylphosphonyl group; amido groups such as an acetylamino group and a benzoylamino group; carbamoyl groups such as an *N*,*N*-dimethylcarbamoyl group; alkyl groups such as a methyl group, an ethyl group, a propyl group, an isopropyl group, a cyclopropyl group, a butyl group, a 2-carboxyethyl group and a benzyl group; aryl groups such as a phenyl group and a toluyl group; heterocyclic groups such as a pyridyl group, an imidazolyl group and a furanyl group; alkenyl groups such as a vinyl group and a 1-propenyl group; silyl groups; silyloxy groups; etc.

The molten salt electrolytes represented by the general formula (Y-a), (Y-b) or (Y-c) may form oligomers or polymers via any one of $Q_{y1}$ and $R_{y1}$ to $R_{y11}$.

In the general formulae (Y-a), (Y-b) and (Y-c), $X^-$ represents an anion. Preferable examples of the anions include halide ions such as $I^-$, $Cl^-$ and $Br^-$, $SCN^-$, $BF_4^-$, $PF_6^-$, $ClO_4^-$, $N^-(SO_2CF_3)_2$, $N^-(SO_2CF_2CF_3)_2$, $CH_3SO_3^-$, $CF_3SO_3^-$, $CF_3COO^-$, $BPh_4^-$, $C^-(SO_2CF_3)_3$, etc. $X^-$ is more preferably $I^-$, $SCN^-$, $BF_4^-$, $N^-(SO_2CF_3)_2$, $CF_3SO_3^-$ or $CF_3COO^-$.

Preferred examples of the molten salt electrolytes are illustrated below without intention of restriction.

Y1

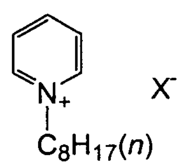

Y1-1: $X^-=I^-$
Y1-2: $X^-=BF_4^-$
Y1-3: $X^-=N^-(SO_2CF_3)_2$
Y1-4: $X^-=PF_6^-$

Y2

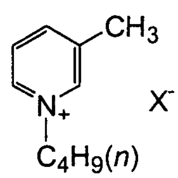

Y2-1: $X^-=I^-$
Y2-2: $X^-=BF_4^-$
Y2-3: $X^-=N^-(SO_2CF_3)_2$
Y2-4: $X^-=CF_3COO^-$
Y2-5: $X^-=SCN^-$
Y2-6: $X^-=CF_3SO_3^-$

Y3

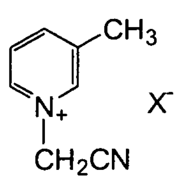

Y3-1: $X^-=I^-$
Y3-2: $X^-=BF_4^-$
Y3-3: $X^-=N^-(SO_2CF_3)_2$

Y4

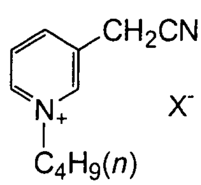

Y4-1: $X^-=I^-$
Y4-2: $X^-=BF_4^-$
Y4-3: $X^-=N^-(SO_2CF_3)_2$

Y5

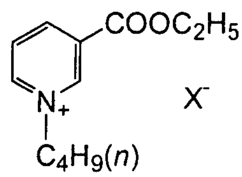

Y5-1: $X^-=I^-$
Y5-2: $X^-=BF_4^-$
Y5-3: $X^-=N^-(SO_2CF_3)_2$

Y6

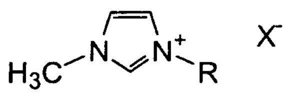

Y6-1: $X^-=I^-$, R=Et
Y6-2: $X^-=BF_4^-$, R=Et
Y6-3: $X^-=N^-(SO_2CF_3)_2$, R=Et
Y6-4: $X^-=Br^-$, R=Et
Y6-5: $X^-=CF_3COO^-$, R=Et
Y6-6: $X^-=SCN^-$, R=Et
Y6-7: $X^-=CF_3SO_3^-$, R=Et
Y6-8: $X^-=I^-$, $R={}^nPr$
Y6-9: $X^-=BF_4^-$, $R={}^nPr$
Y6-10: $X^-=N^-(SO_2CF_3)_2$, $R={}^nPr$
Y6-11: $X^-=I^-$, $R={}^nBu$
Y6-12: $X^-=BF_4^-$, $R={}^nBu$
Y6-13: $X^-=N^-(SO_2CF_3)_2$, $R={}^nBu$

Y7

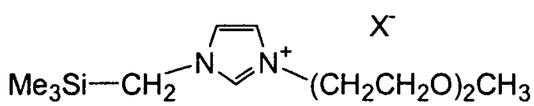

Y7-1: $X^-=I^-$
Y7-2: $X^-=BF_4^-$
Y7-3: $X^-=N^-(SO_2CF_3)_2$
Y7-4: $X^-=CF_3COO^-$
Y7-5: $X^-=SCN^-$

Y8

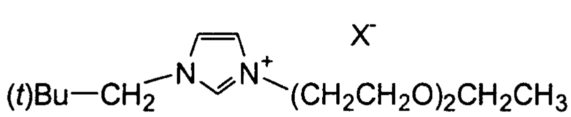

Y8-1: $X^-=I^-$
Y8-2: $X^-=BF_4^-$
Y8-3: $X^-=N^-(SO_2CF_3)_2$
Y8-4: $X^-=PF_6^-$
Y8-5: $X^-=CF_3COO^-$
Y8-6: $X^-=SCN^-$
Y8-7: $X^-=CF_3SO_3^-$

Y9

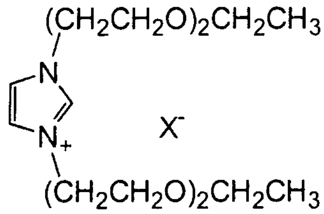

Y9-1: $X^-=I^-$
Y9-2: $X^-=BF_4^-$
Y9-3: $X^-=N^-(SO_2CF_3)_2$
Y9-4: $X^-=CF_3COO^-$
Y9-5: $X^-=SCN^-$
Y9-6: $X^-=CF_3SO_3^-$

Y10

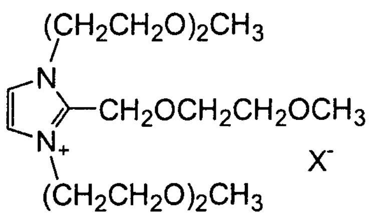

Y10-1: $X^-=I^-$
Y10-2: $X^-=BF_4^-$
Y10-3: $X^-=N^-(SO_2CF_3)_2$

Y11

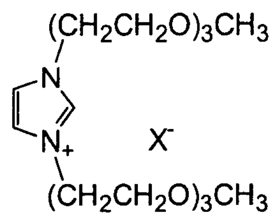

Y11-1: $X^-=I^-$
Y11-2: $X^-=BF_4^-$
Y11-3: $X^-=N^-(SO_2CF_3)_2$

Y12

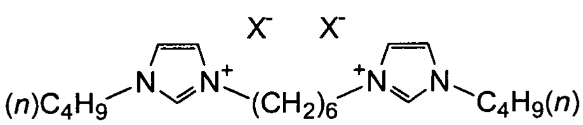

Y12-1: $X^-=I^-$
Y12-2: $X^-=BF_4^-$
Y12-3: $X^-=N^-(SO_2CF_3)_2$

Y13

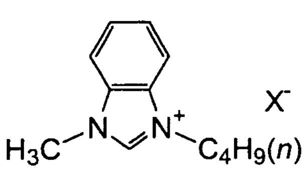

Y13-1: $X^-=I^-$
Y13-2: $X^-=BF_4^-$
Y13-3: $X^-=N^-(SO_2CF_3)_2$

Y14

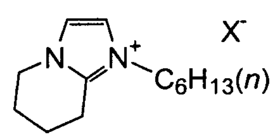

Y14-1: $X^-=I^-$
Y14-2: $X^-=BF_4^-$
Y14-3: $X^-=N^-(SO_2CF_3)_2$

Y15

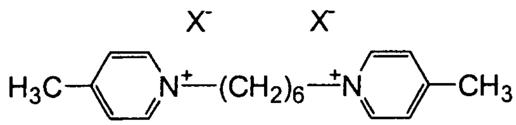

Y15-1: $X^-=I^-$
Y15-2: $X^-=BF_4^-$
Y15-3: $X^-=N^-(SO_2CF_3)_2$

Y16

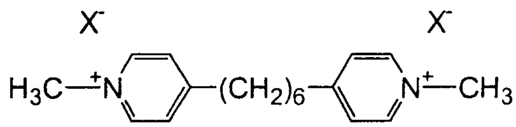

Y16-1: $X^-=I^-$
Y16-2: $X^-=BF_4^-$
Y16-3: $X^-=N^-(SO_2CF_3)_2$

Y17

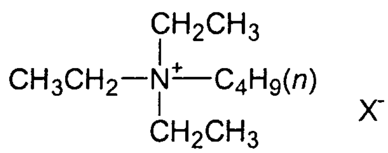

Y17-1: $X^-=I^-$
Y17-2: $X^-=BF_4^-$
Y17-3: $X^-=N^-(SO_2CF_3)_2$
Y17-4: $X^-=PF_6^-$

Y18

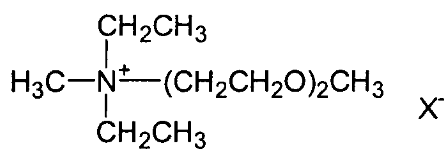

Y18-1: $X^-=I^-$
Y18-2: $X^-=BF_4^-$
Y18-3: $X^-=N^-(SO_2CF_3)_2$

Y19

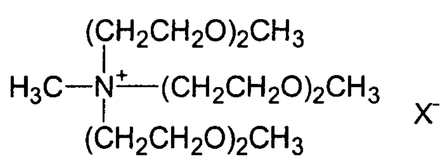

Y19-1: $X^-=I^-$
Y19-2: $X^-=BF_4^-$
Y19-3: $X^-=N^-(SO_2CF_3)_2$
Y19-4: $X^-=CF_3COO^-$
Y19-5: $X^-=SCN^-$
Y19-6: $X^-=CF_3SO_3^-$

Y20

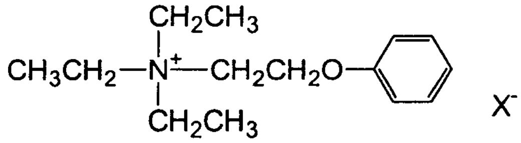

Y20-1: $X^-=I^-$
Y20-2: $X^-=BF_4^-$
Y20-3: $X^-=N^-(SO_2CF_3)_2$

Y21

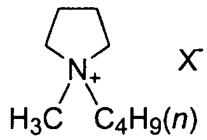

$X^-$

Y21-1: $X^-=I^-$
Y21-2: $X^-=BF_4^-$
Y21-3: $X^-=N^-(SO_2CF_3)_2$

Y22

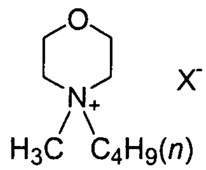

$X^-$

Y22-1: $X^-=I^-$
Y22-2: $X^-=BF_4^-$
Y22-3: $X^-=N^-(SO_2CF_3)_2$

Y23

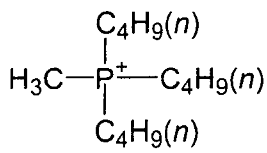

$X^-$

Y23-1: $X^-=I^-$
Y23-2: $X^-=BF_4^-$
Y23-3: $X^-=N^-(SO_2CF_3)_2$

Y24

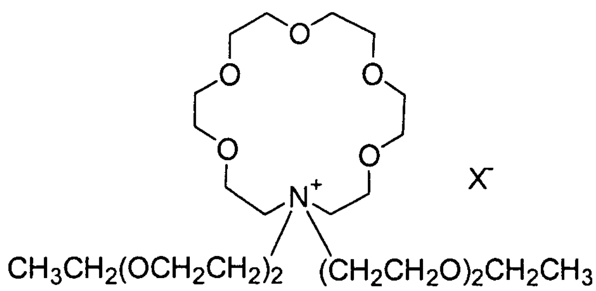

$X^-$

Y24-1: $X^-=I^-$
Y24-2: $X^-=BF_4^-$
Y24-3: $X^-=N^-(SO_2CF_3)_2$

Y25

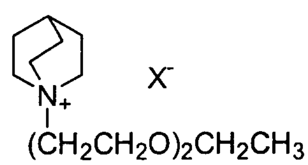

$X^-$

Y25-1: $X^-=I^-$
Y25-2: $X^-=BF_4^-$
Y25-3: $X^-=N^-(SO_2CF_3)_2$

Y26

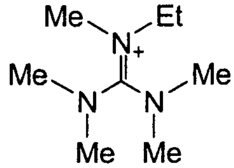

$X^-$

Y26-1: $X^-=I^-$
Y26-2: $X^-=N^-(SO_2CF_3)_2$
Y26-3: $X^-=BF_4^-$
Y26-4: $X^-=PF_6^-$

Y27

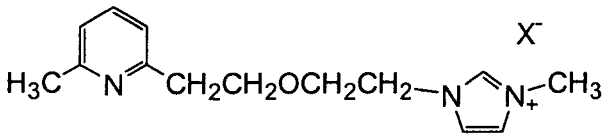

Y27-1: $X^-=I^-$
Y27-2: $X^-=N^-(SO_2CF_3)_2$
Y27-3: $X^-=BF_4^-$
Y27-4: $X^-=CF_3COO^-$
Y27-5: $X^-=SCN^-$
Y27-6: $X^-=CF_3SO_3^-$

Y28

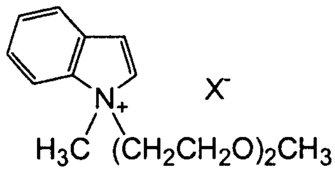

Y28-1: $X^-=I^-$
Y28-2: $X^-=BF_4^-$
Y28-3: $X^-=N^-(SO_2CF_3)_2$

Y29

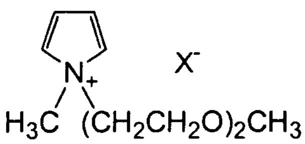

Y29-1: $X^-=I^-$
Y29-2: $X^-=BF_4^-$
Y29-3: $X^-=N^-(SO_2CF_3)_2$

The molten salt electrolytes may be used alone or in combination. The molten salt electrolyte may also be used in combination with another salt such as an iodine salt, e.g. LiI, or an alkali metal salt such as $LiBF_4$, $CF_3COOLi$, $CF_3COONa$, LiSCN and NaSCN. The amount of the alkali metal salt added is preferably 0.02 to 2% by mass, more preferably 0.1 to 1% by mass, based on the entire electrolytic composition.

The molten salt electrolyte is preferably in a molten state at room temperature, and the composition containing this molten salt electrolyte preferably does not comprise a solvent. Though a solvent described below may be added, the content of the molten electrolytic salt is preferably 50% by mass or more, particularly 90% by mass or more, based on the entire electrolytic composition. When the electrolytic composition contains another salt, 50% by mass or more of another salt is preferably occupied by the iodine salt. The molten electrolytic salt composition may be used after gelation as described below.

Iodine is preferably added to the molten electrolytic salt composition. In this case, the iodine content is preferably 0.1 to 20% by mass, more preferably 0.5 to 5% by mass, based on the entire electrolytic composition.

(2) Electrolyte solution

The electrolyte solution used in the present invention is preferably composed of an electrolyte, a solvent and an additive. Examples of the electrolyte used in the electrolyte solution include a combination of $I_2$ and an iodide (a metal iodide such as LiI, NaI, KI, CsI and $CaI_2$, a quaternary ammonium iodide such as tetralkylammonium iodide, pyridinium iodide and imidazolium iodide, etc.); a combination of $Br_2$ and a bromide (a metal bromide such as LiBr, NaBr, KBr, CsBr and $CaBr_2$, a quaternary ammonium bromide such as tetralkylammonium bromide and pyridinium bromide, etc.); a metal complex such as a ferrocyanide-ferricyanide and a ferrocene-ferricinium ion; a sulfur compound such as sodium polysulfide and alkylthiol-alkyldisulfide; a viologen dye; hydroquinone-quinone; etc. Preferable among them is a combination of $I_2$ and LiI or the quaternary ammonium iodide such as pyridinium iodide and imidazolium iodide. These electrolytes may be used in combination.

The concentration of the electrolyte in the electrolyte solution is preferably 0.1 to 10 M, more preferably 0.2 to 4 M. The concentration of iodine is preferably .01 to 0.5 M based on the electrolyte solution.

The solvents used for the electrolyte solution are preferably those having a low viscosity and a high ionic mobility, or those having a high permittivity and capable of increasing the actual carrier concentration of the electrolyte solution, to exhibit an excellent ionic conductibility. Examples of the solvents include carbonates such as ethylene

carbonate and propylene carbonate; heterocyclic compounds such as 3-methyl-2-oxazolidinone; ethers such as dioxan and diethyl ether; chain ethers such as ethylene glycol dialkylethers, propylene glycol dialkylethers, polyethylene glycol dialkylethers and polypropylene glycol dialkylethers; alcohols such as methanol, ethanol, ethylene glycol monoalkylethers, propylene glycol monoalkylethers, polyethylene glycol monoalkylethers and polypropylene glycol monoalkylethers; glycols such as ethylene glycol, propylene glycol, polyethylene glycol, polypropylene glycol and glycerin; nitrile compounds such as acetonitrile, glutarodinitrile, methoxyacetonitrile, propionitrile and benzonitrile; aprotic polar solvents such as dimethylsulfoxide (DMSO) and sulfolane; water; etc. These solvents may be used in combination.

The molten electrolytic salt composition or the electrolyte solution described above preferably comprises a basic compound such as t-butylpyridine, 2-picoline, 2,6-lutidine, etc. described in J. Am. Ceram. Soc., 80, (12), 3157-3171 (1997). When the basic compound is added to the electrolyte solution, the concentration of the basic compound is preferably 0.05 to 2 M based on the electrolyte solution. When the basic compound is added to the molten electrolytic salt composition, the amount of the basic compound is preferably 0.1 to 40% by mass, more preferably 1 to 20% by mass, based on the entire composition.

(3) Electrolytic gel composition

In the present invention, the molten electrolytic salt composition or the electrolyte solution described above may be gelled by adding a polymer or oil-gelling agent, by the polymerization of monomers including a multifunctional monomer, by a cross-linking reaction of a polymer, etc.

In the case of adding a polymer to cause the gelation of the molten electrolytic salt composition or the electrolyte solution, usable polymers may be those described in "Polymer Electrolyte Reviews 1 and 2," edited by J. R. MacCallum and C. A. Vincent, ELSEIVER APPLIED SCIENCE. The preferable polymers are polyacrylonitrile and polyvinylidene fluoride.

In the case of adding an oil-gelling agent to cause the gelation of the molten electrolytic salt composition or the electrolyte solution, usable oil-gelling agents may be those described in J. Chem. Soc. Japan, Ind. Chem. Soc., 46, 779 (1943), J. Am. Chem. Soc., 111, 5542 (1989), J. Chem. Soc., Chem. Commun., 390 (1993), Angew. Chem. Int. Ed. Engl., 35, 1949 (1996), Chem. Lett., 885 (1996), J. Chem. Soc., Chem. Commun., 545 (1997), etc. The preferred oil-gelling agents have an amide structure. The gelation of the electrolyte solution described in JP 11-185863 A and the gelation of the molten electrolytic salt composition described in JP 2000-58140 A are also usable for the present invention.

In the case of the cross-linking reaction of a polymer to cause the gelation of the molten electrolytic salt composition or the electrolyte solution, it is preferable to use a polymer having a cross-linkable group together with a cross-linking agent. The cross-linkable groups are preferably amino groups or nitrogen-containing heterocyclic groups, such as a pyridyl group, an imidazolyl group, a thiazolyl group, an oxazolyl group, a triazolyl group, a morpholyl group, a piperidyl group, a piperazyl group, etc. The cross-linking agent is preferably an electrophilic reagent having a plurality of functional groups that may be subjected to electrophilic reaction with a nitrogen atom, for example, alkyl halides, aralkyl halides, sulfonates, acid anhydrides, acyl chlorides, isocyanates, α,β-unsaturated sulfonyl compounds, α,β-unsaturated carbonyl compounds, α,β-unsaturated nitrile compounds, etc. The cross-linking methods disclosed in JP 2000-17076 A and JP 2000-86724 A may be used in the present invention.

(4) Hole-transporting material

In the present invention, organic, solid, hole-transporting materials, inorganic, solid, hole-transporting materials or a combination thereof may be used for the charge transfer layer instead of the ion conductive electrolytic composition such as the molten electrolytic salt composition.

(a) Organic, hole-transporting materials

Preferable examples of the organic, hole-transporting materials used in the present invention include aromatic amines disclosed in J. Hagen, et al., Synthetic Metal, 89, 215 to 220 (1997), Nature, Vol. 395, October 8, 1998, pages 583 to 585, WO 97/10617, U.S. Patents 4,923,774 and 4,764,625, JP 59-194393 A, JP 5-234681 A, JP 4-308688 A, JP 3-269084 A, JP 4-129271 A, JP 4-175395 A, JP 4-264189 A, JP 4-290851 A, JP 4-364153 A, JP 5-25473 A, JP 5-239455 A, JP 5-320634 A, JP 6-1972 A, JP 7-138562 A, JP 7-252474 A and JP 11-144773 A, etc.; triphenylenes disclosed in JP 11-149821 A, JP 11-148067 A, JP 11-176489 A, etc.; oligothiophene compounds disclosed in Adv. Mater., 9, No. 7, page 557 (1997), Angew. Chem. Int. Ed. Engl., 34, No. 3, pages 303 to 307 (1995), JACS, Vol. 120, No. 4, pages 664 to 672 (1998), etc.; and conductive polymers such as polypyrrole disclosed in K. Murakoshi, et al., Chem. Lett. page 471 (1997) and polyacetylene, poly(*p*-phenylene), poly(*p*-phenylenevinylene), polythienylenevinylene, polythiophene, polyaniline, polytoluidine and derivatives thereof disclosed in Handbook of Organic Conductive

Molecules and Polymers, Vols. 1 to 4, edited by H. S. Nalwa, issued by Wiley.

Nature, Vol. 395, October 8, pages 583 to 585 (1998) describes that added to the organic, hole-transporting material may be a compound having cation radical such as tris(4-bromophenyl)aminium hexachloroantimonate to control the dopant level, or a salt such as $Li[(CF_3SO_2)_2N]$ to control the potential of the semiconductor surface, thereby compensating a space-charge layer.

(b) Inorganic, hole-transporting material

The inorganic, hole-transporting material may be a *p*-type inorganic compound semiconductor. Band gap of the *p*-type inorganic compound semiconductor is preferably 2 eV or more, more preferably 2.5 eV or more. Ionization potential of the *p*-type inorganic compound semiconductor should be smaller than that of the photosensitive layer to reduce holes of the dye. Although the ionization potential of the *p*-type inorganic compound semiconductor may be selected depending on the kind of the dye, generally, it is preferably 4.5 to 5.5 eV, more preferably 4.7 to 5.3 eV. The *p*-type inorganic compound semiconductor is preferably a compound having a monovalent copper such as CuI, CuSCN, $CuInSe_2$, $Cu(In,Ga)Se_2$, $CuGaSe_2$, $Cu_2O$, CuS, $CuGaS_2$, $CuInS_2$, $CuAlSe_2$, etc. Preferable among them are CuI and CuSCN. Particularly preferable among them is CuI. Examples of other *p*-type inorganic compound semiconductors include GaP, NiO, CoO, FeO, $Bi_2O_3$, $MoO_2$, $Cr_2O_3$, etc.

(5) Method for forming charge transfer layer

The charge transfer layer may be formed by any of the following two methods. One method is to attach a counter electrode to a photosensitive layer beforehand and cause a charge transfer material in a liquid state to penetrate into a gap therebetween. Another method is to directly form a charge transfer layer on a photosensitive layer, and then form a counter electrode thereon. In the former method, the charge transfer material may be caused to penetrate into the gap by a normal pressure process utilizing capillarity, or by a reduced pressure process where the material is sucked into the gap to replace a gas phase therein with a liquid phase.

In the case of forming a wet charge transfer material by the latter method, the wet charge transfer material is applied to the photosensitive layer, the counter electrode is disposed on the wet charge transfer material without drying it, and edges thereof are treated to prevent liquid leakage, if necessary. In the case of providing a gel charge transfer layer by the latter method, the charge transfer material may be applied in a liquid state and gelled by polymerization, etc. In this case, a counter electrode may be attached to the charge transfer layer after drying and fixing the charge transfer layer. The application of the electrolytic solution, the wet organic, hole-transporting material, the electrolytic gel composition, etc. may be carried out by the same method as in the above-mentioned application of fine semiconductor particles and dyes.

In the case of a solid, electrolytic composition and a solid, hole-transporting material, the charge transfer layer may be formed by a dry film-forming method such as a vacuum deposition method and a CVD method, followed by attaching a counter electrode thereto. The organic, hole-transporting material may be introduced into the photosensitive layer by a vacuum deposition method, a casting method, a coating method, a spin-coating method, a soaking method, an electrolytic polymerization method, a photo-polymerization method, etc. The inorganic, hole-transporting material may be introduced into the photosensitive layer by a casting method, a coating method, a spin-coating method, a soaking method, an electrolytic deposition method, an electroless deposition method, etc.

(D) Counter electrode

Like the above conductive support, the counter electrode may be an electrically conductive layer alone or a laminate of the electrically conductive layer and the substrate. Examples of electrically conductive materials used for the counter electrode layer include metals such as platinum, gold, silver, copper, aluminum, magnesium and indium; carbon; and electrically conductive metal oxides such as an indium-tin composite oxide and a fluorine-doped tin oxide. Preferable among them are platinum, gold, silver, copper, aluminum and magnesium. The substrate for the counter electrode is preferably a glass or a plastic plate, to which the above electrically conductive material is applied by coating or vapor deposition. The counter electrode layer preferably has a thickness of 3 nm to 10 μm, although the thickness is not particularly limited. The surface resistance of the counter electrode layer is desirably as low as possible. The surface resistance is preferably 50 Ω/square or less, more preferably 20 Ω/square or less.

Because light may be irradiated from either one or both sides of the conductive support and the counter electrode, at least one of them should be substantially transparent so that light can reach the photosensitive layer. To improve the efficiency of power generation, it is preferable that the conductive support is substantially transparent to permit light to pass therethrough. In this case, the counter electrode is preferably reflective to light. Such a counter electrode may be a glass or a plastic plate vapor-deposited with a metal or an electrically conductive oxide, or a thin

metal film.

The counter electrode may be formed by coating, plating or vapor deposition (PVD, CVD, etc.) of the electrically conductive material directly onto the charge transfer layer, or by attaching the electrically conductive layer formed on the substrate to the charge transfer layer. Like in the conductive support, it is preferable to use a metal lead to reduce the resistance of the counter electrode, particularly when the counter electrode is transparent. Preferable materials and formation methods of the metal lead, decrease in the amount of incident light, etc. are the same as in the conductive support.

(E) Other layers

A thin, dense semiconductor film is preferably formed as an undercoating layer between the conductive support and the photosensitive layer, to prevent short-circuiting between the counter electrode and the conductive support. The prevention of short-circuiting by this undercoating layer is effective particularly in the case of the charge transfer layer comprising the electron-transporting material or the hole-transporting material. The undercoating layer is made of preferably $TiO_2$, $SnO_2$, $Fe_2O_3$, $WO_3$, ZnO or $Nb_2O_5$, more preferably $TiO_2$. The undercoating layer may be formed by a spray-pyrolysis method described in Electrochim. Acta, 40, 643-652 (1995), a sputtering method, etc. The thickness of the undercoating layer is preferably 5 to 1000 nm, more preferably 10 to 500 nm.

Functional layers such as a protective layer and a reflection-preventing layer may be formed on either one or both of the conductive support and the counter electrode, between the electrically conductive layer and the substrate, or in the substrate. The functional layers may be formed by a coating method, a vapor deposition method, an attaching method, etc. depending on their materials.

(F) Interior structure of photoelectric conversion device

As described above, the photoelectric conversion device may have various interior structures depending on its use. It is classified into two major structures, one allowing light incidence from both faces, and another allowing it from only one side. Figs. 2 to 9 illustrate the interior structures of the photoelectric conversion device, to which the present invention is preferably applicable. In the structure illustrated in Fig. 2, a photosensitive layer 20 and a charge transfer layer 30 are formed between an electrically conductive, transparent layer 10a and a transparent counter electrode layer 40a. This structure allows light incidence from both sides of the device.

In the structure illustrated in Fig. 3, a transparent substrate 50a partially having a metal lead 11 is provided with an electrically conductive, transparent layer 10a, an undercoating layer 60, a photosensitive layer 20, a charge transfer layer 30 and a counter electrode layer 40 in this order, and further provided with a substrate 50 thereon. This structure allows light incidence from the side of the electrically conductive layer.

In the structure illustrated in Fig. 4, a substrate 50 having an electrically conductive layer 10 is provided with a photosensitive layer 20 via an undercoating layer 60, and then provided with a charge transfer layer 30 and a transparent counter electrode layer 40a thereon, and further provided with a transparent substrate 50a locally having a metal lead 11 inside. This structure allows light incidence from the side of the counter electrode.

In the structure illustrated in Fig. 5, two transparent substrates 50a each partially having a metal lead 11 are provided with an electrically conductive transparent layer 10a or 40a, and then provided with an undercoating layer 60, a photosensitive layer 20 and a charge transfer layer 30 between the conductive layers. This structure allows light incidence from both sides of the photoelectric conversion device.

In the structure illustrated in Fig. 6, a transparent substrate 50a is provided with an electrically conductive transparent layer 10a, an undercoating layer 60, a photosensitive layer 20, a charge transfer layer 30 and a counter electrode layer 40 in this order, and then attached to a substrate 50. This structure allows light incidence from the side of the electrically conductive layer.

In the structure illustrated in Fig. 7, a substrate 50 is provided with an electrically conductive layer 10, an undercoating layer 60, a photosensitive layer 20, a charge transfer layer 30 and a transparent counter electrode layer 40a in this order, and then attached to a transparent substrate 50a. This structure allows light incidence from the side of the counter electrode.

In the structure illustrated in Fig. 8, a transparent substrate 50a is provided with an electrically conductive transparent layer 10a, an undercoating layer 60, a photosensitive layer 20, a charge transfer layer 30 and a transparent counter electrode layer 40a in this order, and then attached to a transparent substrate 50a. This structure allows light incidence from both sides of the photoelectric conversion device.

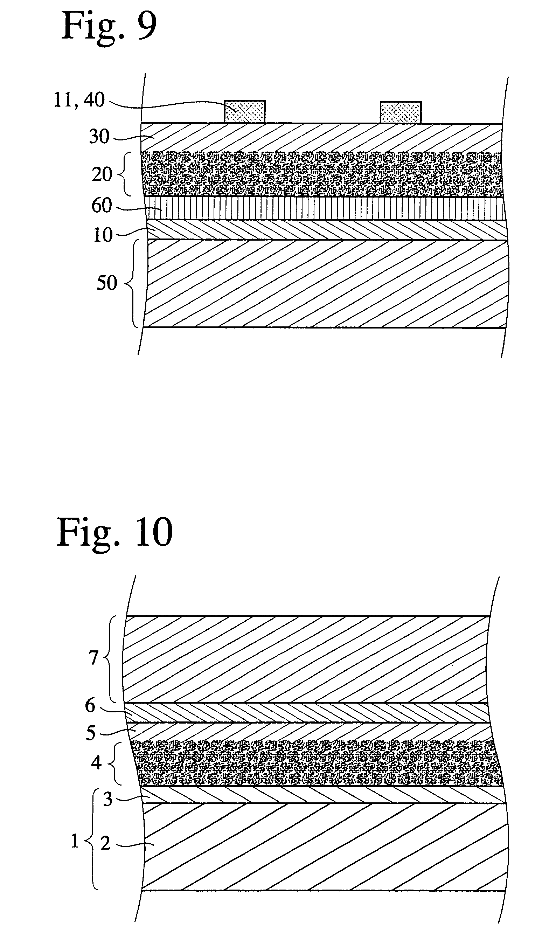

In the structure illustrated in Fig. 9, a substrate 50 is provided with an electrically conductive layer 10, an undercoating layer 60, a photosensitive layer 20, a solid charge transfer layer 30 in this order, and then partially provided with a counter electrode layer 40 or a metal lead 11. This structure allows light incidence from the side of the counter electrode.

[3] Photoelectric cell

The photoelectric cell of the present invention comprises the above photoelectric conversion device of the present invention to do job or generate electricity in an external circuit. Such a photoelectric cell that has the charge transfer layer comprising the ion-conductive electrolytic composition is generally referred to as a photo-electrochemical cell. The photoelectric cell intended for generating power with solar light is referred to as a solar cell.

The edges of the photoelectric cell are preferably sealed with a polymer or an adhesive, etc. to prevent the cell content from deteriorating and evaporating. A known external circuit may be connected to the conductive support and the counter electrode via a lead.

When the photoelectric conversion device of the present invention is used for a solar cell, the interior structure of the solar cell may be essentially the same as that of the photoelectric conversion device mentioned above. The solar cell comprising the photoelectric conversion device of the present invention may have a known module structure. In a general module structure of the solar cell, a cell is disposed on a substrate of metal, ceramic, etc. and covered with a packing resin, a protective glass, etc., whereby light is introduced from the opposite side of the substrate. The solar cell module may have a structure where the cell is placed on a substrate of a transparent material such as a tempered glass to introduce light from the transparent substrate side. Specifically, a superstraight-type module structure, a substrate-type module structure, a potting-type module structure, substrate-integrated module structure that is generally used in amorphous silicon solar cells, etc. are known as the solar cell module structure. The dye-sensitive solar cell of the present invention may have a module structure properly selected from the above structures depending on ends, locations and environment where it is used, and preferably has a module structure disclosed in JP 2000-268892 A, etc.

The present invention will be explained in more detail with reference to Examples below without intention of restricting the scope of the present invention.

Examples 1-8, Comparative Examples 1 and 2

1. Preparation of titanium dioxide dispersion

A dispersion of titanium dioxide particles, whose concentration was 11% by mass, was prepared in the same manner as in the method described in Christophe J. Barb'e, et al, the Journal of American Ceramic Society, Vol. 80, No. 12, page 3157 (1997) except that an autoclave temperature was 230°C. The average particle diameter of the titanium dioxide particles in the dispersion was about 10 nm. Added to and mixed with this dispersion was polyethylene glycol (molecular weight: 20,000, available from Wako Pure Chemical Industries, Ltd) in an amount of 20% by mass based on the titanium dioxide, to obtain a dispersion of titanium dioxide particles.

2. Preparation of dye-adsorbed titanium dioxide electrode

The above dispersion of titanium dioxide particles was applied to an electrically conductive, transparent glass coated with fluorine-doped tin oxide (surface resistance: approximately 10 $\Omega/cm^2$, available from Nippon Sheet Glass Co., Ltd.,) on the conductive layer side at a thickness of 120 µm by a doctor blade, and dried at 25°C for 30 minutes. Thereafter, it was burned at 450°C for 30 minutes in an electric furnace "muffle furnace FP-32" available from YAMATO SCIENTIFIC CO., LTD., and cooled to form a titanium dioxide layer, resulting in a titanium dioxide electrode. The amount of titanium dioxide coated per a unit area (1 m2) of the electrically conductive, transparent glass was 16 $g/m^2$, and the thickness of the titanium dioxide layer was 11 µm.

The above titanium dioxide electrode was cut into the size of 10 mm × 12 mm on the condition that the size of titanium dioxide layer was 10 mm × 10 mm. The resultant titanium dioxide electrode was connected to the negative pole of a power supply, and a platinum plate was connected to the positive pole of the same power supply. The titanium dioxide electrode was laminated on the platinum plate. Next, an electrolyte solution composed of $LiN(CF_3SO_2)_2$ and water was permeated into a gap therebetween. Voltage of 1.5 V was applied from the power supply for 1 hour to conduct electrolytic reduction. After completion of electrolytic reduction, the titanium dioxide electrode and the platinum plate were washed with water and acetonitrile successively, and heat-treated at 550°C for 10 minutes. The concentration of an electrolytic salt in the electrolyte solution was 1.0 mol/L.

After completion of heat treatment, the electrolytically reduced titanium dioxide electrode was cooled, and then immersed in a dye adsorption liquid at 45°C for 3 hours. It was then washed with ethanol and acetonitrile successively and dried in the dark in nitrogen under nitrogen gas stream to provide a dye-adsorbed titanium dioxide electrode E-3. Incidentally, the immersion was carried out with vibration by a vibrator. The above dye adsorption liquid contained dye R-1 in a mixed solvent of ethanol, 2-methyl-2-propanol and acetonitrile (volume ratio of ethanol / 2-methyl-2-propanol / acetonitrile was 1:1:2), and the concentration of the dye R-1 in the dye adsorption liquid was $3 \times 10^{-4}$ mol/L.

A comparative electrode E-1 was produced in the same manner as in the above electrode E-3 except that the above electrolyte solution was replaced by water, and that the electrolytic reduction was not carried out. A comparative electrode E-2 was produced in the same manner as in the above electrode E-3 except that the electrolytic reduction was not carried out. Further, electrodes E-4 to E-10 were produced respectively in the same manner as in the above electrode E-3 except for changing electrolyte solution as shown in Table 1 blow. In the production of the electrode E-4, propylene carbonate was used instead of water when the titanium dioxide electrode and the platinum plate were washed after completion of electrolytic reduction.

Table 1

| Electrode | Electrolyte Solution | | | Conditions of Electrolytic Reduction |
|---|---|---|---|---|
| | Electrolyte Salt | Solvent | Concentration (mol/L) | |
| E-1 | None | Water | - | No voltage applied |
| E-2 | $LiN(CF_3SO_2)_2$ | Water | 1.0 | No voltage applied |
| E-3 | $LiN(CF_3SO_2)_2$ | Water | 1.0 | 1.5 V for 1 hr |
| E-4 | $LiN(CF_3SO_2)_2$ | Propylene Carbonate | 1.0 | 1.5 V for 1 hr |
| E-5 | $LiClO_4$ | Water | 1.0 | 1.5 V for 1 hr |
| E-6 | $CF_3SO_2Li$ | Water | 1.0 | 1.5 V for 1 hr |
| E-7 | $NaNO_3$ | Water | 1.0 | 1.5 V for 1 hr |
| E-8 | $KNO_3$ | Water | 1.0 | 1.5 V for 1 hr |
| E-9 | $Mg(ClO_4)_2$ | Water | 1.0 | 1.5 V for 1 hr |
| E-10 | $Ca(ClO_4)_2$ | Water | 1.0 | 1.5 V for 1 hr |

3. Production of photoelectric conversion device

The above dye-adsorbed titanium dioxide electrode E-3 was laminated on a platinum-vapor-deposited glass of 15 mm $\times$ 20 mm. Next, an electrolyte solution comprising 0.6 mol/L of 1,3-dimethylimidazolium iodide, 0.1 mol/L of lithium iodide and an acetonitrile solution comprising 0.05 mol/L of iodine were permeated into a gap between the two glasses by capillarity to obtain a photoelectric conversion device C-3 of the present invention. This photoelectric conversion device has a structure shown in Fig. 10, in which a conductive glass 1 composed of a glass 2 and a conductive layer 3 laminated thereon, a dye-adsorbed titanium dioxide layer 4, an electrolyte layer 5, a platinum layer 6 and a glass 7 were laminated in this order.

Comparative photoelectric conversion devices C-1 and C-2 and photoelectric conversion devices C-4 to C-10 of the present invention were produced in the same manner as in the photoelectric conversion device C-3 except that the dye-adsorbed titanium dioxide electrode was replaced by those shown in Table 2.

4. Measurement of photoelectric conversion efficiency

A simulated sunlight was obtained by passing light of a 500-W xenon lamp available from USHIO INC. through an "AM 1.5 filter" available from Oriel. The simulated sunlight had intensity of 100 mW/cm$^2$ in a vertical plane. A silver paste was applied to an edge of an electrically conductive glass in each of the photoelectric conversion devices C-1 to C-10 to form a negative electrode, and the negative electrode and a platinum-deposited glass as a positive electrode were connected to a current-voltage tester "Keithley SMU238." While vertically irradiating the simulated sunlight to each photoelectric conversion device, its current-voltage characteristics were measured to determine its photoelectric conversion efficiency. The photoelectric conversion efficiency of each photoelectric conversion device is shown in Table 2.

Table 2

| Photoelectric Conversion Device | Electrode | Photoelectric Conversion Efficiency (%) | Note |
|---|---|---|---|
| C-1 | E-1 | 4.8 | Comparative Example 1 |

Table 2 (continued)

| Photoelectric Conversion Device | Electrode | Photoelectric Conversion Efficiency (%) | Note |
|---|---|---|---|
| C-2 | E-2 | 4.9 | Comparative Example 2 |
| C-3 | E-3 | 7.0 | Example 1 |
| C-4 | E-4 | 6.3 | Example 2 |
| C-5 | E-5 | 6.9 | Example 3 |
| C-6 | E-6 | 6.9 | Example 4 |
| C-7 | E-7 | 6.0 | Example 5 |
| C-8 | E-8 | 6.2 | Example 6 |
| C-9 | E-9 | 5.8 | Example 7 |
| C-10 | E-10 | 5.7 | Example 8 |

As shown in Table 2, the photoelectric conversion devices C-3 to C-10 of the present invention comprising electrolytically reduced semiconductor particles are excellent in photoelectric conversion efficiency, as compared with the comparative photoelectric conversion devices C-1 and C-2.

The comparison of the photoelectric conversion devices C-3 to C-8 with the photoelectric conversion devices C-9 and C-10 has revealed that the electrolyte salt used for the electrolytic reduction preferably comprises an alkali metal ion, more preferably comprises $Li^+$. Further, the comparison of the photoelectric conversion device C-3 with the photoelectric conversion device C-4 has revealed that the solvent used for the electrolytic reduction is preferably water.

As explained above in detail, the dye-sensitized photoelectric conversion device excellent in photoelectric conversion efficiency can be obtained by the method of the present invention comprising the step of electrolytically reducing fine semiconductor particles.

## Claims

1. A method for producing a photoelectric conversion device comprising a conductive support and a photosensitive layer containing fine semiconductor particles onto which a dye is adsorbed, comprising the step of electrolytically reducing said fine semiconductor particles.

2. The method for producing a photoelectric conversion device according to claim 1, wherein an electrolyte solution comprising an electrolyte salt and a solvent is used in the electrolytic reduction of said fine semiconductor particles.

3. The method for producing a photoelectric conversion device according to claim 2, wherein said electrolyte salt comprises an alkali metal ion or an alkaline earth metal ion.

4. The method for producing a photoelectric conversion device according to claim 2 or 3, wherein said electrolyte salt comprises an anion selected from the group consisting of a nitrate ion, $ClO_4^-$, $BF_4^-$, $PF_6^-$, $SbF_6^-$, $AsF_6^-$, a trifluoromethane sulfonate ion, a bis(trifluoroethanesulfonyl)imide ion and a tris(trifluoromethanesulfonyl)methide ion.

5. The method for producing a photoelectric conversion device according to any one of claims 2 to 4, wherein said solvent is water.

6. The method for producing a photoelectric conversion device according to any one of claims 1 to 5, wherein the electrolytic reduction of said fine semiconductor particles is carried out before said dye is adsorbed on said fine semiconductor particles.

7. The method for producing a photoelectric conversion device according to any one of claims 1 to 6, wherein 10 nA to 10 mA of current is provided per 1 $cm^2$ of said conductive support in the step of said electrolytic reduction of said fine semiconductor particles.

**8.** The method for producing a photoelectric conversion device according to any one of claims 1 to 7, wherein said fine semiconductor particles is oxide.

**9.** The method for producing a photoelectric conversion device according to 8, wherein said fine semiconductor particles is titanium oxide.

**10.** The method for producing a photoelectric conversion device according to any one of claims 1 to 9, wherein said dye is a ruthenium complex dye.

**11.** A photoelectric conversion device produced by the method recited in any one of claims 1 to 10.

**12.** A photoelectric cell comprising the photoelectric conversion device recited in claim 11.

Fig. 1

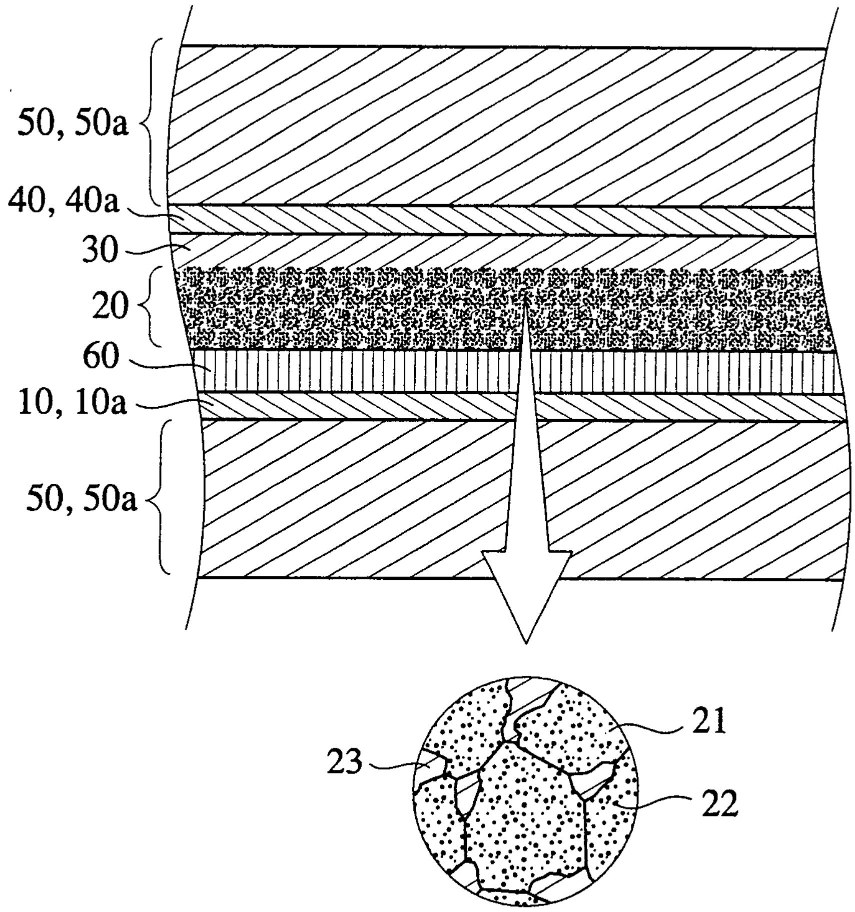


Fig. 2

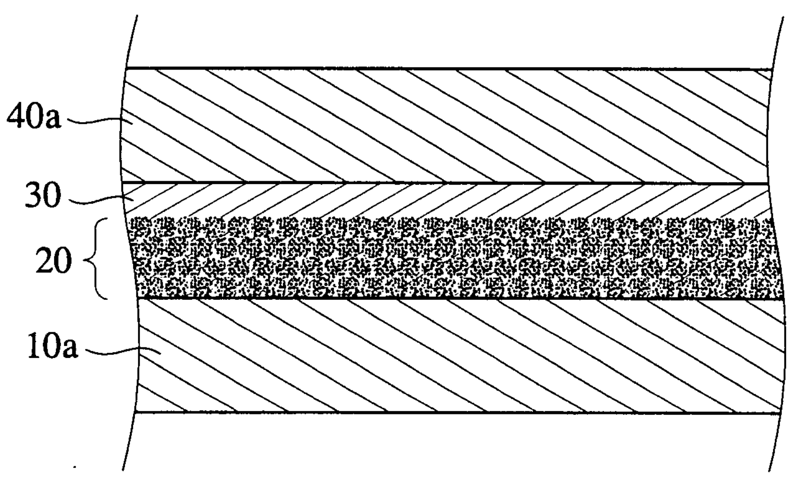

Fig. 3

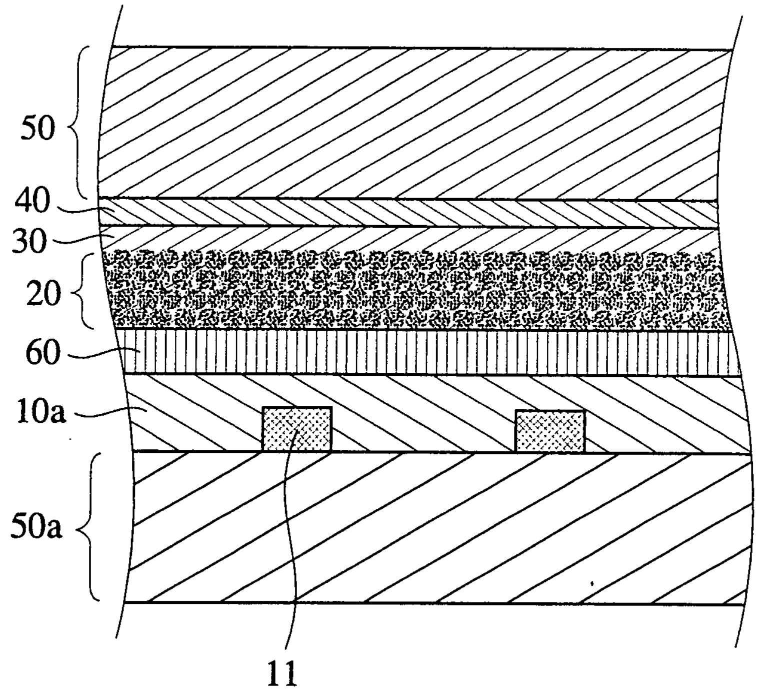


Fig. 4

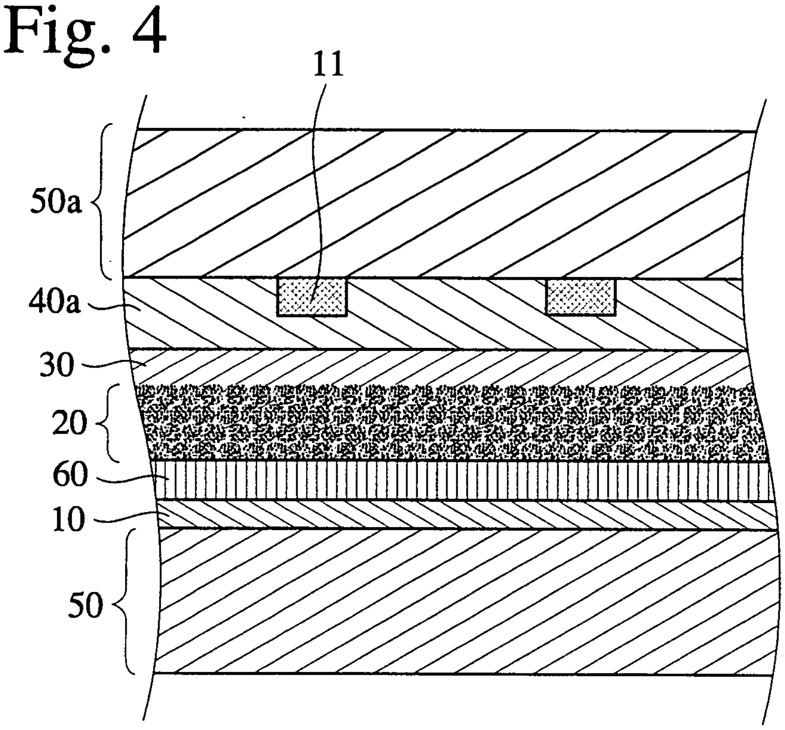

Fig. 5

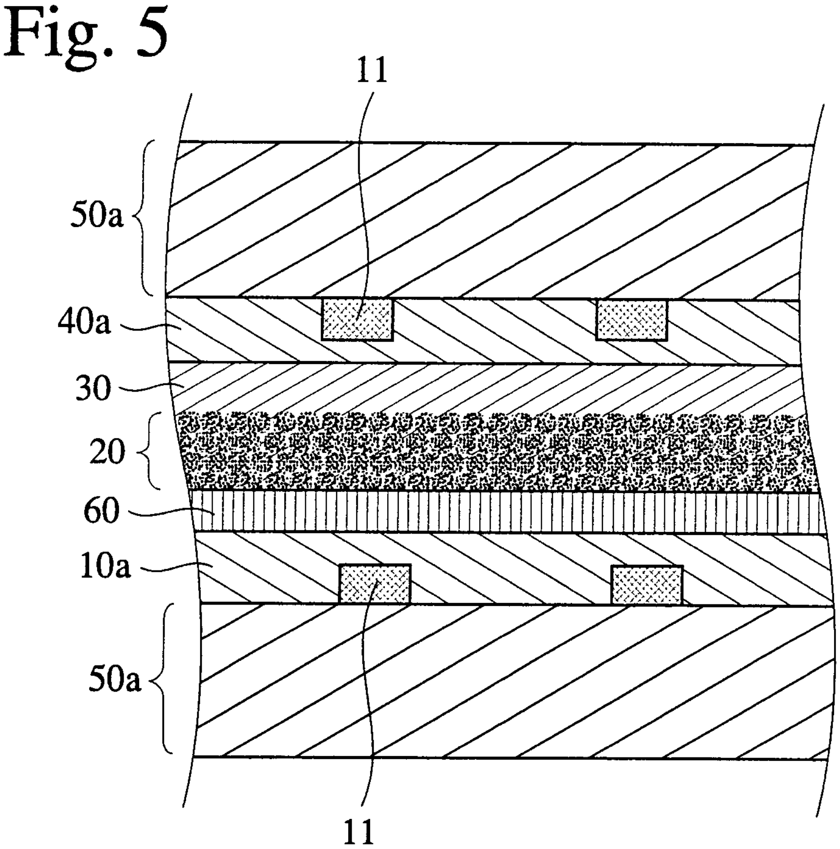


Fig. 6

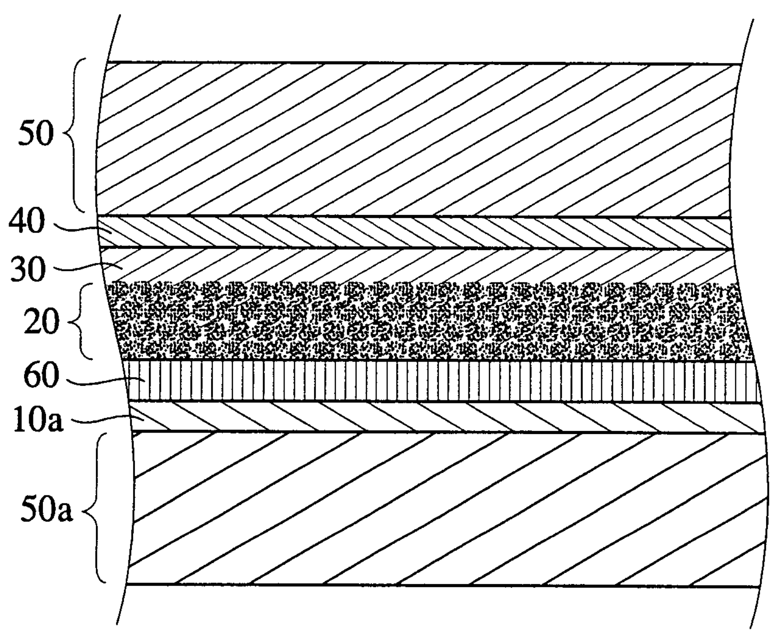

# Fig. 7

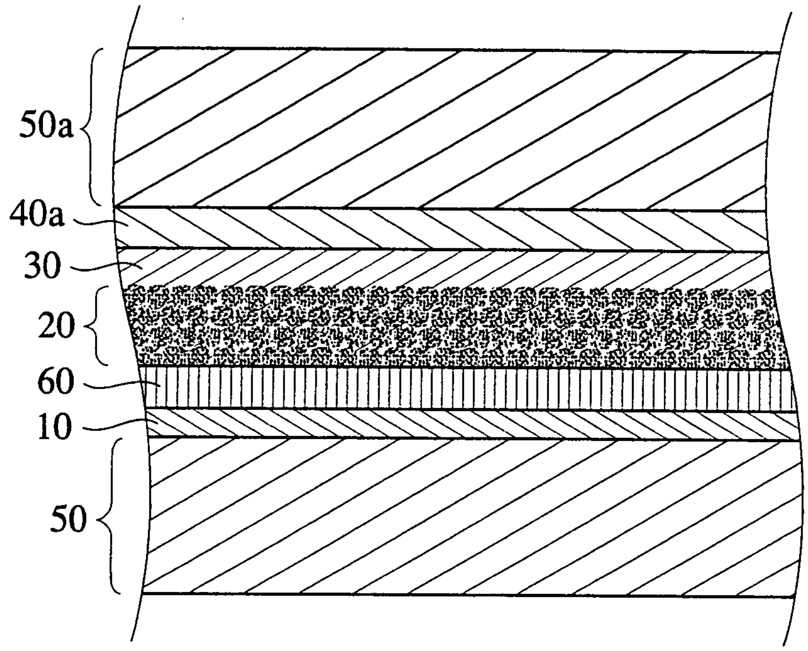


# Fig. 8

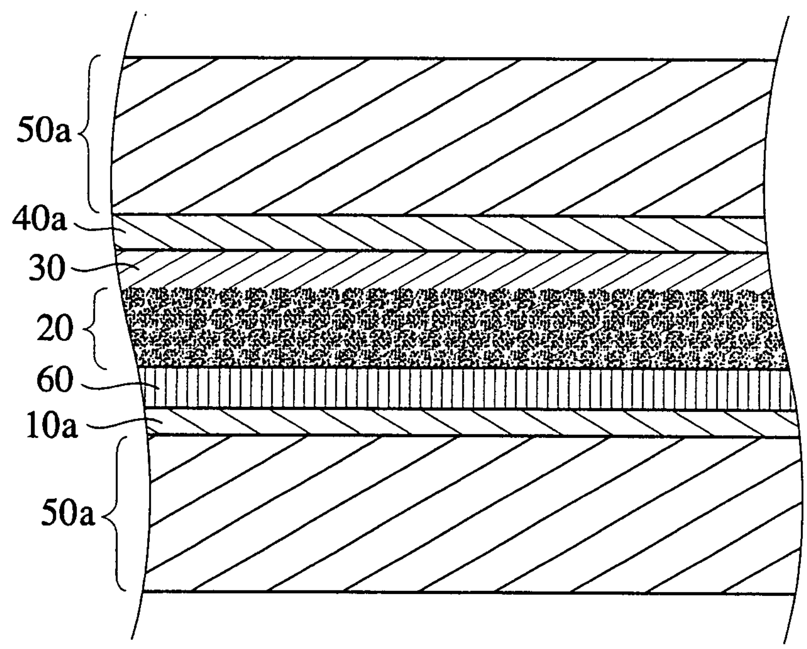

Fig. 9

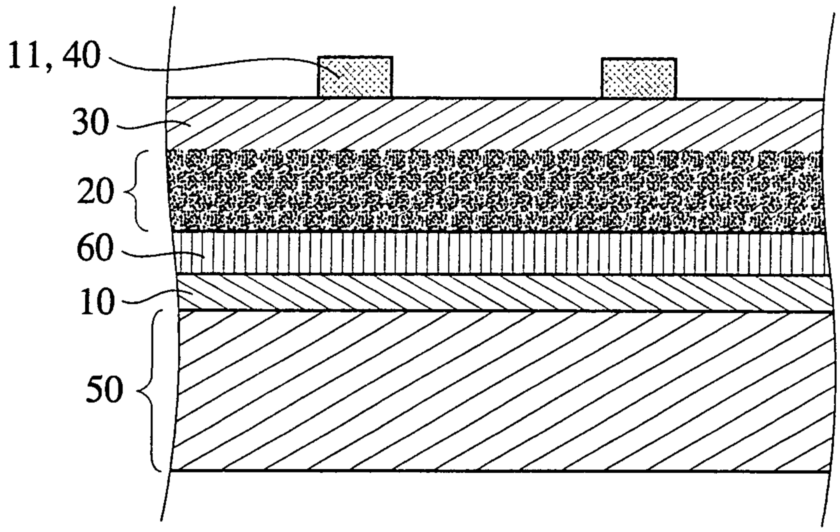


Fig. 10